# EUROPEAN PATENT APPLICATION

(11) **EP 4 832 717 A1**
(43) Date of publication of application: **28.10.2026**
(21) Application number: 24908244.7
(22) Date of filing: 18.11.2024
(51) Int. Cl.: H10K 59/126, H10K 77/10, H10K 59/121, H10D 30/67, H10K 59/131, H10K 59/12, H10K 71/60

(54) **DISPLAY DEVICE AND MANUFACTURING METHOD THEREFOR**

(30) Priority: 22.12.2023 KR 20230189962
(71) Applicant: Samsung Display Co., Ltd., Yongin-si, Gyeonggi-do 17113 (KR)
(72) Inventor: HAN, Jae Bum, Yongin-si, Gyeonggi-do 17113 (KR); YEON, Ki Young, Yongin-si, Gyeonggi-do 17113 (KR); KIM, Moon Sung, Yongin-si, Gyeonggi-do 17113 (KR)
(74) Representative: Marks & Clerk LLP
(86) International application number: PCT/KR2024/096604
(87) International publication number: WO 2025/135962

(57) **Abstract**

A display device according to an embodiment includes: a substrate: a first bottom electrode disposed on the substrate; a first passivation layer disposed on the first bottom electrode and including a first additive and at least one of silicon nitride, silicon oxide, and silicon oxynitride; a first insulation layer disposed on the first passivation layer; an active layer disposed on the first insulation layer and including an oxide semiconductor; a gate insulation layer disposed on the active layer; a gate electrode disposed on the gate insulation layer; and a second insulation layer disposed on the gate electrode. The first bottom electrode may include a first metal layer and a second metal layer disposed on the first metal layer and exposing a side surface of the first metal layer. The first passivation layer may cover the exposed side surface of the first metal layer.

## Description

### [Technical Field]

Embodiments of the present disclosure relate to a display device and a method for manufacturing the same.

### [Background Art]

With the advance of information-oriented society, more and more demands are placed on display devices for displaying images in various ways. Along with this trend, various types of display devices including a light emitting display device are being developed.

### [Detailed Description of the Invention]

### [Technical Problem]

The problem to be solved by the present disclosure is to provide a display device with improved reliability and a method for manufacturing the same.

The tasks of the present invention are not limited to the tasks mentioned above, and other technical tasks not mentioned will be clearly understood by those skilled in the art from the description below.

### [Technical Solution]

A display device according to an embodiment include a substrate, a first bottom electrode disposed on the substrate, a first passivation layer disposed on the first bottom electrode, and containing at least one of silicon nitride, silicon oxide, and silicon oxynitride, and a first additive, a first insulating layer disposed on the first passivation layer, an active layer disposed on the first insulating layer, and containing an oxide semiconductor, a gate insulating layer disposed on the active layer, a gate electrode disposed on the gate insulating layer, and a second insulating layer disposed on the gate electrode. The first bottom electrode may include a first metal layer and a second metal layer disposed on the first metal layer and exposing a side surface of the first metal layer. The first passivation layer may cover the exposed side surface of the first metal layer.

In an embodiment, the first metal layer may contain aluminium or copper, and the second metal layer may contain titanium.

In an embodiment, the first bottom electrode may further include a third metal layer disposed below the first metal layer and containing titanium.

In an embodiment, the first additive may contain at least one of fluorine, chlorine, carbon, and sulfur.

In an embodiment, a concentration of fluorine, chlorine, carbon, or sulfur contained in the first passivation layer may be equal to or greater than 2.5 times a concentration of fluorine, chlorine, carbon, or sulfur contained in the first insulating layer.

In an embodiment, the first passivation layer may contain fluorine-added silicon nitride, and a thickness of the first passivation layer may be 100 Å or less.

In an embodiment, the first insulating layer may include, a silicon nitride layer disposed on the first passivation layer, and at least one of a silicon oxide layer and a silicon oxynitride layer disposed on the silicon nitride layer.

In an embodiment, the active layer may contain at least one of indium-gallium-zinc oxide, indium-tin-gallium-zinc oxide, and indium-gallium oxide.

In an embodiment, the gate electrode may include a fourth metal layer containing aluminium or copper, and may further include at least one of a fifth metal layer containing titanium and disposed on the fourth metal layer and a sixth metal layer containing titanium and disposed below the fourth metal layer.

In an embodiment, the display device may further include a second passivation layer disposed between the gate electrode and the second insulating layer to cover the gate electrode, and containing silicon oxide or silicon oxynitride and a second additive.

In an embodiment, the second additive display device contain at least one of fluorine, chlorine, carbon, and sulfur.

In an embodiment, the second insulating layer may contain at least one of silicon oxide and silicon oxynitride.

In an embodiment, the display device may further include a barrier layer disposed between the substrate and the first bottom electrode, a second bottom electrode disposed between the substrate and the barrier layer, and a third passivation layer disposed between the second bottom electrode and the barrier layer to cover the second bottom electrode, and containing at least one of silicon nitride, silicon oxide, and silicon oxynitride and a third additive.

In an embodiment, the second bottom electrode may include a seventh metal layer containing aluminium or copper, and may further include at least one of an eighth metal layer disposed on the seventh metal layer and containing titanium and a ninth metal layer disposed below the seventh metal layer and containing titanium.

In an embodiment, the third additive may contain at least one of fluorine, chlorine, carbon, and sulfur.

In an embodiment, the display device may further include at least one of a source electrode and a drain electrode, the source and drain electrodes being disposed on the second insulating layer and electrically connected to the active layer, and the first bottom electrode may overlap the active layer and may be electrically connected to the source electrode.

A method for manufacturing a display device according to an embodiment includes forming, on a substrate, a first bottom electrode including a first metal layer and a second metal layer on the first metal layer, forming, on the substrate, a first passivation layer covering the first bottom electrode and containing at least one of silicon nitride, silicon oxide, and silicon oxynitride and a first additive, forming a first insulating layer on the first passivation layer, forming an active layer containing an oxide semiconductor on the first insulating layer, forming a gate insulating layer and a gate electrode on the active layer, and forming a second insulating layer on the active layer, the gate insulating layer, and the gate electrode. The second metal layer may expose a side surface of the first metal layer, and the first passivation layer may cover the exposed side surface of the first metal layer.

In an embodiment, the first additive may contain at least one of fluorine, chlorine, carbon, and sulfur.

In an embodiment, the method may further include, before forming the second insulating layer, forming a second passivation layer covering the gate electrode and containing silicon oxide or silicon oxynitride and a second additive, and the second additive may contain at least one of fluorine, chlorine, carbon, and sulfur.

In an embodiment, the method may further include, before forming the first bottom electrode, sequentially forming, on the substrate, a second bottom electrode, a third passivation layer covering the second bottom electrode, and a barrier layer covering the third passivation layer, and the third passivation layer may contain at least one of silicon nitride, silicon oxide, and silicon oxynitride, and a third additive containing at least one of fluorine, chlorine, carbon, and sulfur.

Other details of the embodiments are included in the detailed description and the drawings.

### [Effects of the Invention]

In the display device and the method for manufacturing the same according to embodiments, it is possible to reduce the resistance of a conductive layer provided in a display panel while effectively preventing corrosion of the conductive layer. Accordingly, the operating characteristics and reliability of the display device may be improved.

The effects according to the embodiments are not limited to the contents exampled above, and more diverse effects are included in the present disclosure.

### [Brief Description of the Drawings]

FIG. 1 is a plan view illustrating a display device according to one embodiment;
FIG. 2 is a plan view illustrating a display panel of FIG. 1;
FIG. 3 is a circuit diagram illustrating a pixel according to one embodiment;
FIG. 4 is a cross-sectional view illustrating the display panel according to one embodiment;
FIG. 5 is a cross-sectional view showing area A1 of FIG. 4 in detail;
FIG. 6 is a cross-sectional view showing area A1 of FIG. 4 in detail;
FIG. 7 is a cross-sectional view illustrating the display panel according to one embodiment;
FIG. 8 is a cross-sectional view showing area A2 of FIG. 7 in detail;
FIG. 9 is a cross-sectional view showing area A2 of FIG. 7 in detail;
FIG. 10 is a cross-sectional view illustrating the display panel according to one embodiment;
FIG. 11 is a cross-sectional view showing area A3 of FIG. 10 in detail;
FIG. 12 is a cross-sectional view showing area A3 of FIG. 10 in detail;
FIG. 13 is a graph showing a fluorine concentration measured in the display panel including a first passivation layer; and
FIGS. 14 to 25 are cross-sectional views illustrating a method for manufacturing the display device according to one embodiment.

### [Mode for Invention]

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being "on" another element or layer, the element or layer can be directly on another element or layer or intervening elements or layers. Like reference numerals refer to like elements throughout the specification. Shapes, sizes, ratios, angles, numbers, etc. disclosed in the drawings for describing embodiments are merely an example, and the present disclosure is not limited to the illustrated details.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, specific embodiments will be described with reference to the accompanying drawings.

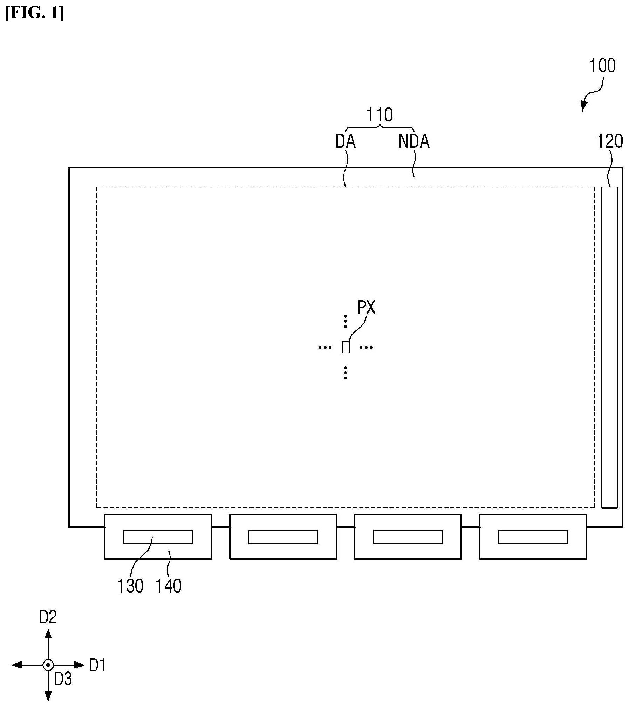

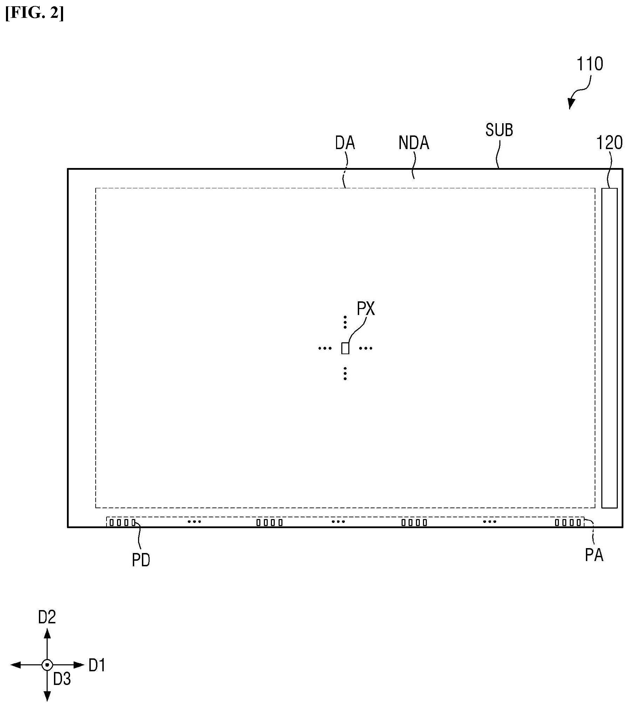

FIG. 1 is a plan view illustrating a display device 100 according to one embodiment. FIG. 2 is a plan view illustrating a display panel 110 of FIG. 1.

Referring to FIGS. 1 and 2, the display device 100 is a device for displaying a moving image or a still image. The display device 100 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC). These are presented as nothing more than examples, and the display device 100 may be included in or applicable to various other types of electronic devices.

In one embodiment, the display device 100 may be a light emitting display device such as an organic light emitting display including an organic light emitting diode, a quantum dot light emitting display including a quantum dot light emitting layer, an inorganic light emitting display including an inorganic semiconductor, or an ultra-small light emitting display including an ultra-small light emitting diode such as a micro or nano light emitting diode (micro LED or nano LED), but is not limited thereto. For example, the display device 100 may be another type of display device other than a light emitting display device. In the following, embodiments in which the display device 100 is a light emitting display device (e.g., an organic light emitting display device) will be disclosed.

The display device 100 may include the display panel 110 including pixels PX, and a first driver 120 and a second driver 130 configured to supply driving signals to the pixels PX. The display device 100 may further include additional components. For example, the display device 100 may further include a power supply unit for supplying power voltages to the pixels PX, the first driver 120, and the second driver 130, and a timing controller for controlling the operations of the first driver 120 and the second driver 130.

The display panel 110 may include a display area DA and a non-display area NDA. The display area DA may be an area including the pixels PX to display an image. For example, the display area DA may include pixel areas where the pixels PX are arranged. The non-display area NDA is an area other than the display area DA, and an image may not be displayed in the non-display area NDA. In one embodiment, the non-display area NDA may be positioned around the display area DA and may surround the display area DA.

In FIGS. 1 and 2, a first direction D1, a second direction D2, and a third direction D3 are defined. In one embodiment, the first direction D1 may be the horizontal direction of the display panel 110, and the second direction D2 may be the vertical direction of the display panel 110. The third direction D3 may be a thickness direction of the display panel 110.

In one embodiment, the display panel 110 may have a rectangular shape in plan view. Although FIGS. 1 and 2 illustrate the display panel 110 with a horizontal length longer than a vertical length, the shape of the display panel 110 is not limited thereto. For example, the display panel 110 may have a shape with a vertical length longer than a horizontal length, a square shape, or the like. The display panel 110 may include an angled corner or a rounded corner.

The planar shape of the display panel 110 is not limited to the illustrated quadrilateral shape, and it may be applied in other shapes. For example, the display panel 110 may have a non-quadrilateral polygonal shape, a circular shape, an elliptical shape, an atypical shape, or another shape in plan view.

In one embodiment, the display panel 110 may be substantially flat on the plane defined by the first direction D1 and the second direction D2, and may have a uniform thickness in the third direction D3. Alternatively, the display panel 110 may be provided in a three-dimensional shape having a curved surface or the like.

The display panel 110 may be provided as a rigid panel so as not to be substantially transformed, or as a flexible panel that can be transformed to be at least partially folded, bent, or rolled. The display panel 110 may be provided to the display device 100 without bending, or may be provided to the display device 100 while being partially bent.

The display panel 110 may include a substrate SUB and pixels PX disposed on the substrate SUB. The pixels PX may be disposed in the display area DA on the substrate SUB.

The substrate SUB, which is a base member for manufacturing or providing the display panel 110, may form the base surface of the display panel 110. The substrate SUB may include the display area DA and the non-display area NDA around the display area DA.

The display area DA may have various shapes depending on embodiments. For example, the display area DA may have a quadrilateral shape, a non-quadrilateral polygonal shape, a circular shape, an elliptical shape, an atypical shape, or another shape. In one embodiment, the display area DA may have a shape conforming to the shape of the display panel 110.

The pixels PX may be provided and/or arranged in the display area DA. For example, the display area DA may include a plurality of pixel areas in which the respective pixels PX are disposed.

In one embodiment, the display device 100 may be a light emitting display device, and each pixel PX may include a light emitting element located in each emission area and a pixel circuit connected to the light emitting element. In describing embodiments, the term "connect" may include electrical connection and/or physical connection. Each pixel circuit may include transistors (e.g., transistors including a driving transistor that generates a driving current corresponding to a data signal, and at least one switching transistor) and at least one capacitor (e.g., a capacitor including a storage capacitor).

The non-display area NDA may include a pad area PA where pads PD are disposed. In one embodiment, the non-display area NDA may further include a driving circuit area located on at least one side of the display area DA. At least one driver, the pads PD, and/or wires may be disposed in the non-display area NDA.

At least one driver for driving the pixels PX, or a part of the driver may be disposed in the driving circuit area. For example, circuit elements constituting the first driver 120 (e.g., driver transistors and driver capacitors constituting the stage circuits of the first driver 120) may be disposed in the driving circuit area on the substrate SUB. In one embodiment, the circuit elements of the first driver 120 may be formed in the display panel 110 together with the pixels PX. In one embodiment, the driving transistors provided in the first driver 120 may be transistors having a type and/or a structure that are substantially the same as or similar to those of the transistors provided in the pixels PX, and may be formed simultaneously with the transistors of the pixels PX.

The pads PD may be disposed in the pad area PA. At least one circuit board 140 may be disposed and/or bonded on the pad area PA. In one embodiment, a plurality of circuit boards 140 connected to different pads PD may be disposed on the pad area PA. The pads PD may include signal pads and power pads for transmitting driving signals and power voltages required for driving the pixels PX and/or the first driver 120 into the display panel 110.

The first driver 120 and the second driver 130 may generate driving signals for controlling operation timing, luminance, and the like of the pixels PX, and may supply the generated driving signals to the pixels PX. For example, the first driver 120 may be a gate driver including a scan driver, and may be connected to the pixels PX through respective gate lines. The first driver 120 may supply respective gate signals (e.g., control signals for controlling the driving timing of the pixels PX, including scan signals and/or emission control signals) to the pixels PX. The second driver 130 may be a data driver including source driving circuits, and may be connected to the pixels PX through respective data lines. The second driver 130 may supply respective data signals to the pixels PX.

In one embodiment, at least one first driver of the first driver 120 or the second driver 130, or a part of the at least one first driver may be embedded in the display panel 110. For example, the first driver 120 or a part of the first driver 120 may be disposed and/or formed in the non-display area NDA and disposed on the substrate SUB of the display panel 110.

Although FIG. 1 illustrates that the first driver 120 is formed on one side of the display area DA (for example, in the non-display area NDA on the right side of the display area DA), but the embodiments are not limited thereto. For example, the first driver 120 may be positioned only on the other side (e.g., the non-display area NDA on the left side of the display area DA) of the display area DA, or may be positioned on both sides (e.g., the non-display area NDA on the left side and right side of the display area DA) of the display area DA. Alternatively, a part of the first driver 120 may be portioned in the non-display area NDA, and another part of the first driver 120 may be positioned in a non-emission area (e.g., an area between emission areas of the pixels PX) inside the display area DA.

In one embodiment, the other driver of the first driver 120 and the second driver 130 or a part of the other driver may be disposed or formed outside the display panel 110 to be electrically connected to the display panel 110. For example, the second driver 130 may be implemented as a multiple number of integrated circuit chips, which may be disposed on the circuit boards 140 electrically connected to the pixels PX of the display panel 110. The second driver 130 may be implemented as at least one integrated circuit chip and mounted on the non-display area NDA of the display panel 110.

The circuit board 140 may be connected to the display panel 110 through the pads PD. In one embodiment, the circuit board 140 may be a flexible film such as a flexible printed circuit board (FPCB), a printed circuit board (PCB), or a chip on film (COF), but is not limited thereto. In one embodiment, the circuit board 140 may be connected to the timing controller and/or the power supply unit through another circuit board, connector, or the like.

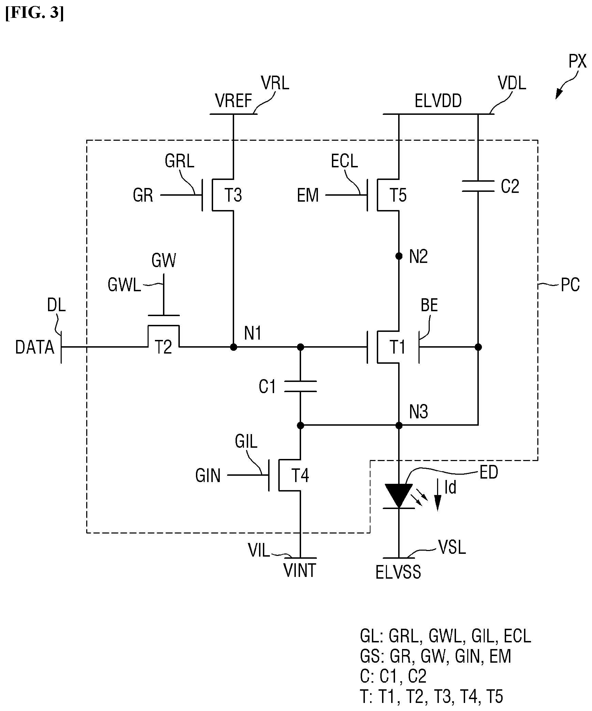

FIG. 3 is a circuit diagram illustrating the pixel PX according to one embodiment. For example, FIG. 3 shows the pixel PX of the light emitting display device including a light emitting element ED. The type and/or structure of the pixel PX that may be included in the display device 100 may be variously changed depending on embodiments.

Referring to FIG. 3, the pixel PX may include the light emitting element ED, and a pixel circuit PC connected to the light emitting element ED. The light emitting element ED is a light source of the pixel PX, and it may be, for example, an organic light emitting diode, but is not limited thereto. The pixel circuit PC may control the emission time point and the luminance of the light emitting element ED.

The pixel circuit PC may include transistors T and at least one capacitor C. For example, the pixel circuit PC may include first to fifth transistors T1 to T5, and first and second capacitors C1 and C2. Although FIG. 3 shows an embodiment in which all the transistors T are N-type transistors, the types of the transistors T are not limited thereto. For example, at least one transistor T may be formed of a P-type transistor.

The pixel circuit PC may supply a driving current Id to the light emitting element ED in response to the driving signals supplied from the first driver 120 and the second driver 130. For example, the pixel circuit PC may supply the driving current Id to the light emitting element ED in response to respective gate signals GS supplied from the first driver 120 through respective gate lines GL and a data signal DATA supplied from the second driver 130 through a data line DL.

The first transistor T1 may be a driving transistor of the pixel PX whose magnitude of drain-source current (e.g., the driving current Id) is determined depending on the gate-source voltage. The second, third, fourth, and fifth transistors T2, T3, T4, and T5 may be switching transistors that are turned on or off depending on respective gate-source voltages. Depending on the type (for example, P-type or N-type) and/or operating conditions of each of the first to fifth transistors T1 to T5, a first electrode of each of the first to fifth transistors T1 to T5 may be a drain electrode (or a drain region), or a source electrode (or a source region), and a second electrode thereof may be an electrode different from the first electrode. For example, when the first electrode is a drain electrode, the second electrode may be a source electrode.

The pixel PX may be connected to a first gate line GWL that transmits a first gate signal GW (e.g., a scan signal), a second gate line GIL that transmits a second gate signal GIN, a third gate line GRL that transmits a third gate signal GR, an emission control line ECL that transmits an emission control signal EM, and the data line DL that transmits the data signal DATA. Further, the pixel PX may be connected to a first power line VDL that transmits a first pixel voltage ELVDD (also referred to as "first pixel power voltage"), and a second power line VSL that transmits a second pixel voltage ELVSS (also referred to as "second pixel power voltage"). In one embodiment, the pixel PX may be further connected to an initialization power line VIL that transmits an initialization voltage VINT (also referred to as "third pixel power voltage"), and a reference power line VRL that transmits a reference voltage VREF (also referred to as "fourth pixel power voltage").

In one embodiment, the first to fifth transistors T1 to T5 may be located in each pixel area, and may be oxide transistors (also referred to as "oxide semiconductor transistors") including an oxide semiconductor. By way of example, an active layer of each of the first to fifth transistors T1 to T5 may include the oxide semiconductor. However, the embodiments are not limited thereto. For example, at least one transistor T may be formed of a semiconductor material (for example, amorphous silicon or polysilicon) other than an oxide semiconductor.

In one embodiment, the transistors T, including the first to fifth transistors T1 to T5, disposed in the display panel 110 may all be oxide transistors including oxide semiconductors. The oxide semiconductor may have high carrier mobility and a low leakage current, so that a considerable voltage drop may not occur even if the driving time of the oxide transistor increases. For example, the pixel PX including an oxide transistor may be driven at a low frequency because the change in the luminance and/or the color of an image due to a voltage drop is not significant even when it is driven at a low frequency. When the first to fifth transistors T1 to T5 are formed of oxide transistors, the leakage current of the pixel PX may be reduced or prevented and the power consumption may be reduced.

The oxide semiconductor is sensitive to light, so that the amount of current or the like may be changed due to external light. In one embodiment, a light blocking pattern or a light blocking electrode (e.g., a bottom electrode or a back-gate electrode) may be disposed under the active layer included in at least one transistor T to block external light. Accordingly, the operating characteristics of the transistor T may be stabilized.

The first transistor T1 may include a gate electrode connected to a first node N1, a first electrode (for example, a drain electrode) connected to a second node N2, and a second electrode (for example, a source electrode) connected to a third node N3. The first electrode of the first transistor T1 may be connected to the first power line VDL via the fifth transistor T5, and the second electrode thereof may be connected to the light emitting element ED. The first transistor T1 may control the magnitude (e.g., current amount) of the driving current Id flowing to the light emitting element ED to correspond to the data signal DATA transmitted to the first node N1.

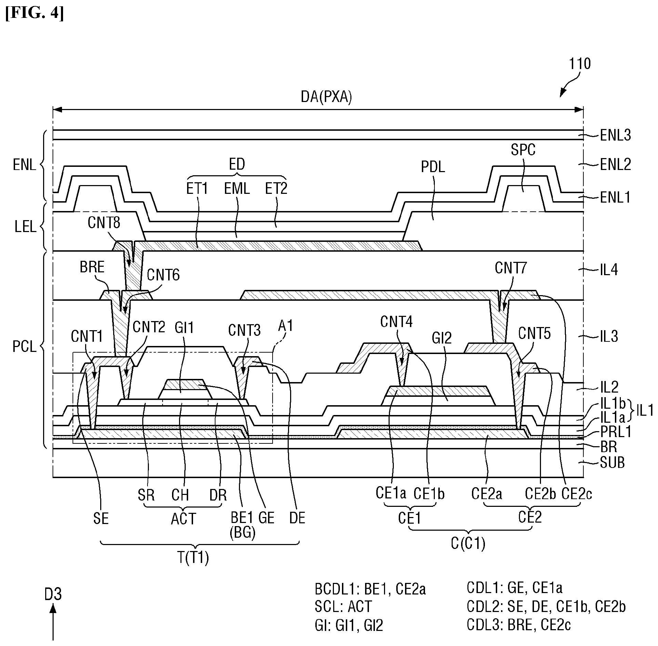

In one embodiment, the first transistor T1 may further include a bottom electrode BE (e.g., a first bottom electrode BE1 in FIG. 4) connected to the third node N3. When the first transistor T1 is formed of a transistor having a double gate structure (e.g., a double gate transistor having a source-sync structure) by connecting the bottom electrode BE of the first transistor T1 to the third node N3, the operating characteristics of the first transistor T1 may be improved.

The second transistor T2 may include a gate electrode connected to the first gate line GWL, a first electrode connected to the data line DL, and a second electrode connected to the first node N1. The second transistor T2 may be turned on by the first gate signal GW (for example, the first gate signal GW of the gate-on voltage) transmitted to the first gate line GWL to connect the data line DL and the first node N1. Accordingly, the data signal DATA transmitted through the data line DL may be sent to the first node N1.

The third transistor T3 may include a gate electrode connected to the third gate line GRL, a first electrode connected to the reference power line VRL, and a second electrode connected to the first node N1. The third transistor T3 may be turned on by the third gate signal GR transmitted through the third gate line GRL and transmit the reference voltage VREF transmitted to the reference power line VRL to the first node N1.

The fourth transistor T4 may include a gate electrode connected to the second gate line GIL, a first electrode connected to the third node N3, and a second electrode connected to the initialization power line VIL. The fourth transistor T4 may be turned on by the second gate signal GIN transmitted through the second gate line GIL and transmit the initialization voltage VINT transmitted to the initialization power line VIL to the third node N3.

The fifth transistor T5 may include a gate electrode connected to the emission control line ECL, a first electrode connected to the first power line VDL, and a second electrode connected to the second node (or the first electrode of the first transistor T1). The fifth transistor T5 may be turned on by the emission control signal EM (for example, the emission control signal EM of the gate-on voltage) transmitted to the emission control line ECL to control the emission time point of the pixel PX.

Each of the second to fifth transistors T2 to T5 may or may not include the bottom electrode. In one embodiment, at least one switching transistor among the second to fifth transistors T2 to T5 may include the bottom electrode, and the bottom electrode of the at least one switching transistor may be connected to the gate electrode of the corresponding switching transistor. In the case that the bottom electrode of the switching transistor is connected to the gate electrode, it is possible to improve the off characteristics and the switching speed of the switching transistor, secure an additional voltage tolerance range, lower a leakage current, and improve voltage stability.

The first capacitor C1 may be connected between the first node N1 and the third node N3. The first capacitor C1 is a storage capacitor of the pixel PX, and may store therein a threshold voltage of the first transistor T1 and a voltage corresponding to the data signal DATA (e.g., a data voltage).

The second capacitor C2 may be connected between the first power line VDL and the third node N3. In one embodiment, the capacitance of the second capacitor C2 may be less than that of the first capacitor C1.

The light emitting element ED may be connected between the third node N3 and the second power line VSL. For example, the light emitting element ED may include a first electrode (e.g., an anode electrode) connected to the third node N3, a second electrode (e.g., a cathode electrode) facing the first electrode and connected to the second power line VSL, and a light emitting layer interposed between the first electrode and the second electrode. In one embodiment, the first electrode of the light emitting element ED may be an individual electrode individually provided in each pixel PX, and the second electrode of the light emitting element ED may be a common electrode shared by a plurality of pixels PX. The light emitting element ED may emit light with a luminance corresponding to the driving current Id during a time period in which the driving current Id is supplied from the pixel circuit PC.

FIG. 4 is a cross-sectional view illustrating the display panel 110 according to one embodiment. For example, FIG. 4 shows a part of the display area DA of the display panel 110. FIG. 4 illustrates a light emitting display panel including the light emitting element ED (for example, an organic light emitting diode) as an example of the display panel 110 to which embodiments may be applied.

Referring to FIG. 4, the display panel 110 may include the substrate SUB (or a base layer), a panel circuit layer PCL, a light emitting element layer LEL, and an encapsulation layer ENL. The panel circuit layer PCL, the light emitting element layer LEL, and the encapsulation layer ENL may be disposed to overlap each other on the substrate SUB. For example, with respect to the display area DA, the panel circuit layer PCL, the light emitting element layer LEL, and the encapsulation layer ENL may be sequentially disposed on the substrate SUB along the third direction D3. The positions of the panel circuit layer PCL, the light emitting element layer LEL, and/or the encapsulation layer ENL may change depending on embodiments.

In one embodiment, the display panel 110 may further include additional elements provided above and/or under the encapsulation layer ENL. For example, the display panel 110 may further include at least one of a sensor layer (for example, a touch sensor layer), an optical layer (for example, a color filter layer and/or a wavelength conversion layer), or a passivation layer (for example, a passivation film, an insulating layer, an upper substrate, and/or a window). Each of the sensor layer, the optical layer, and/or the passivation layer may be provided above the encapsulation layer ENL or may be provided between the light emitting element layer LEL and the encapsulation layer ENL.

The substrate SUB, which is a base member for forming the display panel 110, may be a rigid or flexible substrate (or film). In one embodiment, the substrate SUB may be a substrate including an insulating material such as glass or the like and having rigid characteristics, and may not be bent. Alternatively, the substrate SUB may be a flexible substrate that includes polyimide or another insulating material and may be transformed to be bent, folded, or rolled, and may or may not be bent. The type and/or material of the substrate SUB may change depending on embodiments.

A panel circuit layer PCL (for example, a pixel circuit layer or a thin film transistor layer) may be disposed on the substrate SUB. The panel circuit layer PCL may include circuit elements including the transistors T and the capacitors C of the pixels PX, and wires (e.g., signal lines and power lines). In one embodiment, the panel circuit layer PCL may further include circuit elements (e.g., driving transistors and/or driving capacitors provided in the first driver 120) of the first driver 120, and/or additional conductive patterns (e.g., bridge patterns).

FIG. 4 shows the transistor T and the capacitor C disposed in any one pixel area PXA, as an example of the circuit elements that may be provided in the panel circuit layer PCL. The transistor T of FIG. 4 may be a driving transistor or a switching transistor provided in the pixel circuit PC of the corresponding pixel PX. For example, the transistor T of FIG. 4 may be the first transistor T1 of FIG. 3. The capacitor C of FIG. 4 may be any one capacitor C provided in the pixel circuit PC of the corresponding pixel PX. For example, the capacitor C of FIG. 4 may be the first capacitor C1 of FIG. 3.

In one embodiment, the panel circuit layer PCL may include a barrier layer BR. In one example, the barrier layer BR may be disposed on the substrate SUB, and circuit elements and wires may be disposed on the barrier layer BR.

The panel circuit layer PCL may include a semiconductor layer SCL and conductive layers disposed on the barrier layer BR. The electrodes constituting the circuit elements (e.g., the transistors T and the capacitors C) of the panel circuit layer PCL, and wires and/or the conductive patterns (e.g., bridge electrodes BRE) connected to the circuit elements may be provided in the conductive layers. The active layers ACT of the transistors T provided in the panel circuit layer PCL may be provided in the semiconductor layer SCL.

In one embodiment, the panel circuit layer PCL may include a first bottom conductive layer BCDL1 (also referred to as "first lower conductive layer" or "fourth conductive layer"), the semiconductor layer SCL, a first conductive layer CDL1 (also referred to as "gate conductive layer"), and a second conductive layer CDL2 (also referred to as "first source-drain conductive layer" or "first data conductive layer") that are sequentially disposed on the substrate SUB along the third direction D3. In one embodiment, the panel circuit layer PCL may further include a third conductive layer CDL3 (also referred to as "second source-drain conductive layer" or "second data conductive layer") disposed on the second conductive layer CDL2. For example, the first bottom conductive layer BCDL1 may be disposed below the semiconductor layer SCL (e.g., between the substrate SUB and the semiconductor layer SCL), and the first conductive layer CDL1, the second conductive layer CDL2, and the third conductive layer CDL3 may be disposed above the semiconductor layer SCL (e.g., between the semiconductor layer SCL and the light emitting element layer LEL).

The respective electrodes, conductive patterns, and/or wires provided or disposed on the conductive layers of the panel circuit layer PCL may include at least one conductive material. For example, the electrodes, the conductive patterns, and/or the wires disposed in each of the first bottom conductive layer BCDL1, the first conductive layer CDL1, the second conductive layer CDL2, and the third conductive layer CDL3 may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), and other metals, an alloy thereof, or another conductive material. In one embodiment, the electrodes, the conductive patterns, and/or the wires disposed on the same conductive layer may be simultaneously formed using the same conductive material.

In one embodiment, each of the electrodes, conductive patterns, and/or wires provided in the conductive layers of the panel circuit layer PCL may have a single-layer or multi-layer structure. For example, each of the electrodes, conductive patterns, and/or wires provided in the first bottom conductive layer BCDL1, the first conductive layer CDL1, the second conductive layer CDL2, and the third conductive layer CDL3 may have a single-layer or multiple-layer structure. In one embodiment, the electrodes, the conductive patterns, and/or the wires provided on the same conductive layer may be simultaneously formed using the same material.

The panel circuit layer PCL may further include a plurality of insulating layers and/or insulating patterns disposed on the substrate SUB. For example, the panel circuit layer PCL may include the barrier layer BR, a first insulating layer IL1, a gate insulating layer GI, a second insulating layer IL2, a third insulating layer IL3, and a fourth insulating layer IL4 that are sequentially disposed on the substrate SUB along the third direction D3. In embodiments, the panel circuit layer PCL may further include a first passivation layer PRL1 disposed between the first bottom conductive layer BCDL1 and the first insulating layer IL1.

The barrier layer BR may be disposed between the substrate SUB and the first bottom conductive layer BCDL1. The barrier layer BR may include at least one inorganic insulating layer containing an inorganic insulating material (e.g., silicon nitride, silicon oxide, silicon oxynitride, titanium oxide, aluminium oxide, or another inorganic insulating material). The barrier layer BRL may protect the pixels PX from moisture permeating through the substrate SUB that is susceptible to moisture permeation. The material of the barrier layer BRL may be variously changed according to embodiments.

The first passivation layer PRL1 may be disposed on the barrier layer BR (or the substrate SUB) and the first bottom conductive layer BCDL1. The first passivation layer PRL1 may cover the patterns of the first bottom conductive layer BCDL1. For example, the first passivation layer PRL1 may be disposed on electrodes (e.g., the first bottom electrode BE1, and a first sub-electrode CE2a of a second capacitor electrode CE2), wires, and/or conductive patterns included in the first bottom conductive layer BCDL1 to cover the electrodes, wires, and/or conductive patterns of the first bottom conductive layer BCDL1.

The first passivation layer PRL1 may contain a material that can adequately protect the patterns of the first bottom conductive layer BCDL1 from moisture, chemical solutions used in the manufacturing process of the display panel 110, or the like. For example, the first passivation layer PRL1 may contain an insulating material (e.g., an inorganic insulating material) and a first additive added to the insulating material. In one embodiment, the first passivation layer PRL1 may contain at least one of silicon nitride (SiNₓ), silicon oxide (SiOₓ), and silicon oxynitride (SiON), and the first additive (or a first material) added (e.g., doped or deposited) thereto. In one example, the first passivation layer PRL1 may be a silicon nitride layer, a silicon oxide layer, or a silicon oxynitride layer, containing the first additive. In one embodiment, silicon nitride (SiNₓ) may be used to form the first passivation layer PRL1, thereby increasing the barrier effect of blocking the diffusion of moisture, hydrogen, or the like.

In one embodiment, the first additive may contain at least one of fluorine (F), chlorine (Cl), carbon (C), and sulfur (S). For example, the first passivation layer PRL1 may contain fluorine (F)-doped silicon nitride (SiNₓ:F), chlorine (Cl)-doped silicon nitride (SiNₓ:Cl), carbon (C)-doped silicon nitride (SiNₓ:C), sulfur (S)-doped silicon nitride (SiNₓ:S), fluorine (F)-doped silicon oxide (SiOₓ:F) or silicon oxynitride (SiON:F), chlorine (Cl)-doped silicon oxide (SiOₓ:Cl) or silicon oxynitride (SiON:Cl), carbon (C)-doped silicon oxide (SiOₓ:C) or silicon oxynitride (SiON:C), or sulfur (S)-doped silicon oxide (SiOₓ:S) or silicon oxynitride (SiON:S). The concentration of the first additive, e.g., fluorine (F), chlorine (Cl), carbon (C), or sulfur (S), contained in the first passivation layer PRL1 may be equal to or greater than 2.5 times the concentration of fluorine (F), chlorine (Cl), carbon (C), or sulfur (S) contained in the first insulating layer IL1 (or a first layer IL1a of the first insulating layer IL1) on the first passivation layer PRL1.

The first insulating layer IL1 may be disposed on the first bottom conductive layer BCDL1 and the first passivation layer PRL1. The first insulating layer IL1 may include at least one inorganic insulating layer containing an inorganic insulating material.

In one embodiment, the first insulating layer IL1 may be an insulating layer of more than one layer. For example, the first insulating layer IL1 may include the first layer IL1a (e.g., a silicon nitride layer) disposed on the first passivation layer PRL1 and containing silicon nitride (SiNₓ), and a second layer IL1b (e.g., at least one of a silicon oxide layer or a silicon oxynitride layer) disposed on the first layer IL1a and containing at least one of silicon oxide (SiOₓ) and silicon oxynitride (SiON).

As the first insulating layer IL1 includes the first layer IL1a and the second layer IL1b made of different materials, the insulating properties of the first insulating layer IL1 may be improved or secured. For example, by disposing the first insulating layer IL1 formed as at least a double layer between the first bottom electrode BE1 and the active layer ACT, which overlap each other with the first insulating layer IL1 interposed therebetween, the first bottom electrode BE1 and the active layer ACT may be stably insulated and defects such as short circuits may be prevented.

Further, by covering the first bottom conductive layer BCDL1 and the like with the first layer IL1a containing silicon nitride (SiNₓ) which has an excellent hydrogen blocking effect, it is possible to effectively block hydrogen from entering the semiconductor layer SCL from the first bottom conductive layer BCDL1 and the like. Accordingly, changes in the characteristics of the transistor T may be prevented, and the operating characteristics of the transistor T may be improved or stabilized.

The gate insulating layer GI may be disposed on the first insulating layer IL1 and the semiconductor layer SCL. For example, the gate insulating layer GI may be disposed between the first insulating layer IL1 and the semiconductor layer SCL and the first conductive layer CDL1. The gate insulating layer GI may cover a part of each of the first insulating layer IL1 and the semiconductor layer SCL. The gate insulating layer GI may include at least one inorganic insulating layer containing an inorganic insulating material (e.g., silicon oxide (SiOₓ)).

The second insulating layer IL2 may be disposed on the first insulating layer IL1, the semiconductor layer SCL, the gate insulating layer GI, and the first conductive layer CDL1. For example, the second insulating layer IL2 may be disposed between the first conductive layer CDL1 and the second conductive layer CDL2. The second insulating layer IL2 may be disposed on the patterns of the semiconductor layer SCL, the gate insulating layer GI, and the first conductive layer CDL1 to cover the corresponding patterns. For example, the second insulating layer IL2 may be disposed on the active layers ACT provided in the semiconductor layer SCL, a first gate insulating layer GI1 and a second gate insulating layer GI2 provided in the gate insulating layer GI, and a gate electrode GE of the transistor T and a first sub-electrode CE1a of a first capacitor electrode CE1 provided in the first conductive layer CDL1.

The second insulating layer IL2 may include at least one inorganic insulating layer containing an inorganic insulating material. In one example, the second insulating layer IL2 may be a single-layer or multilayer insulating layer containing at least one of silicon oxide (SiOₓ) and silicon oxynitride (SiON).

In one embodiment, the second insulating layer IL2 may be an insulating layer of more than one layer. For example, the second insulating layer IL2 may include a lower layer disposed on the first conductive layer CDL1 and containing silicon oxide (SiOₓ) or silicon oxynitride (SiON), and an upper layer disposed on the lower layer and containing silicon nitride (SiNₓ). By first covering the active layer ACT with the silicon oxide layer or the silicon oxynitride layer, it is possible to prevent or reduce hydrogen from entering or diffusing into the active layer ACT from the silicon nitride layer or the like. In addition, by covering the silicon oxide layer or the silicon oxynitride layer with the silicon nitride layer, it is possible to block hydrogen from entering or diffusing into the active layer ACT from other surrounding conductive layers, insulating layers, or the like. Accordingly, the active layer ACT may be stably protected and the operating characteristics of the transistor T may be improved or secured.

The third insulating layer IL3 may be disposed on the second insulating layer IL2 and the second conductive layer CDL2. For example, the third insulating layer IL3 may be disposed between the second conductive layer CDL2 and the third conductive layer CDL3. The third insulating layer IL3 may be disposed on the patterns of the second conductive layer CDL2 to cover the corresponding patterns. For example, the third insulating layer IL3 may be disposed on a source electrode SE and a drain electrode DE of the transistor T, a second sub-electrode CE1b of the first capacitor electrode CE1, and a second sub-electrode CE2b of the second capacitor electrode CE2 that are provided in the second conductive layer CDL2, and the like.

The third insulating layer IL3 may include at least one organic insulating layer containing an organic insulating material (e.g., acryl resin, epoxy resin, phenolic resin, polyamide resin, polyimide resin, or other organic insulating materials). The third insulating layer IL3 may include an inorganic insulating layer or may not include an inorganic insulating layer. When the third insulating layer IL3 includes an inorganic insulating layer, the inorganic insulating layer and the organic insulating layer of the third insulating layer IL3 may be sequentially disposed on the second conductive layer CDL2. The surface (for example, the top surface) of the third insulating layer IL3 may be substantially flat.

The fourth insulating layer IL4 may be disposed on the third insulating layer IL3 and the third conductive layer CDL3. For example, the fourth insulating layer IL4 may be disposed between the third conductive layer CDL3 and the light emitting element layer LEL. The fourth insulating layer IL4 may be disposed on the patterns of the third conductive layer CDL3 and cover the patterns. For example, the fourth insulating layer IL4 may be disposed on the bridge electrode BRE and a third sub-electrode CE2c of the second capacitor electrode CE2 that are provided in the third conductive layer CDL3, and the like.

The fourth insulating layer IL4 may include at least one organic insulating layer including an organic insulating material. The fourth insulating layer IL4 may include an inorganic insulating layer or may not include an inorganic insulating layer. When the fourth insulating layer IL4 includes an inorganic insulating layer, the inorganic insulating layer and the organic insulating layer of the fourth insulating layer IL4 may be sequentially disposed on the third conductive layer CDL3. The surface (for example, the top surface) of the fourth insulating layer IL4 may be substantially flat.

In one embodiment, at least one insulating layer provided in the panel circuit layer PCL may be disposed entirely in the display area DA. For example, the barrier layer BR, the first insulating layer IL1, the second insulating layer IL2, the third insulating layer IL3, and the fourth insulating layer IL4 may be disposed entirely in the display area DA.

In one embodiment, the gate insulating layer GI may be partially disposed only in each pixel area PXA and a part of the display area DA including the same. In one embodiment, the gate insulating layer GI may include the first gate insulating layer GI1 (also referred to as "first gate insulating pattern") disposed on a part of each active layer ACT provided in the semiconductor layer SCL, and the second gate insulating layer GI2 (also referred to as "second gate insulating pattern") disposed on the first insulating layer IL1 without overlapping the active layer ACT. For example, the first gate insulating layer GI1 may be disposed between a part of the active layer ACT including a channel region CH and the gate electrode GE, and the second gate insulating layer GI2 may be disposed between the first insulating layer IL1 and the first sub-electrode CE1a of the first capacitor electrode CE1. The first gate insulating layer GI1 and the second gate insulating layer GI2 may be connected to each other to form an integrated insulating pattern, or may be individual insulating patterns that are separated from each other in plan view. However, the embodiments are not limited thereto. For example, the gate insulating layer GI may be disposed entirely in the display area DA to entirely cover the first insulating layer IL1 and the semiconductor layer SCL.

The transistor T may include the active layer ACT (also referred to as "active pattern" or "semiconductor pattern") and the gate electrode GE (e.g., a top-gate electrode) disposed on a part of the active layer ACT. In one embodiment, the transistor T may further include at least one of a source electrode SE or a drain electrode DE. For example, the transistor T may further include the source electrode SE connected to a source region SR of the active layer ACT and the drain electrode DE connected to a drain region DR of the active layer ACT. Alternatively, the transistor T may not include a separate source electrode and/or a separate drain electrode, and the source region SR and/or the drain region DR of the first active layer ACT may be connected to another circuit element, wire, and/or conductive pattern to function as the source electrode and/or the drain electrode of the transistor T.

In one embodiment, the transistor T may further include the first bottom electrode BE1 (or a bottom-gate electrode) disposed under the active layer ACT. For example, the first bottom electrode BE1 may be connected to one electrode of the transistor T, and may be utilized as a back-gate electrode BG for adjusting the characteristics of the transistor T. Since the first bottom electrode BE1 is disposed under the active layer ACT, it is possible to block external light from being incident on the channel region CH of the active layer ACT, and stabilize the operating characteristics of the transistor T.

FIG. 4 illustrates an embodiment in which the transistor T is formed in a double-gate structure including the first bottom electrode BE1 and the gate electrode GE that overlap each other with the active layer ACT interposed therebetween, but embodiments are not limited thereto. For example, the transistor T may include only one of the first bottom electrode BE1 and the gate electrode GE. In one example, the transistor T may be formed in a top-gate structure including the single gate electrode GE disposed above the active layer ACT, or may be formed in a bottom-gate structure including the first bottom electrode BE1 disposed below the active layer ACT.

In one embodiment, the transistor T may be an oxide transistor. For example, the transistor T may be an N-type oxide transistor.

The first bottom electrode BE1 may be provided in the first bottom conductive layer BCDL1 disposed on the barrier layer BR (or the substrate SUB). The first bottom conductive layer BCDL1 may be disposed between the barrier layer BR and the first insulating layer IL1, and may be covered by the first passivation layer PRL1. Each of the patterns of the first bottom conductive layer BCDL1 may be formed as a single layer (e.g., a single metal layer), or as multiple layers of two or more layers (e.g., two or more metal layers).

The first bottom electrode BE1 may overlap the active layer ACT and the gate electrode GE. For example, the first bottom electrode BE1 may be disposed under the active layer ACT to overlap at least a part of the active layer ACT including the channel region CH, and may face the gate electrode GE with the active layer ACT interposed therebetween.

In one embodiment, the first bottom electrode BE1 may be connected to the source electrode SE or the gate electrode GE of the transistor T. For example, the transistor T may be a driving transistor (e.g., the first transistor T1 in FIG. 3) of the pixel PX, and the first bottom electrode BE1 disposed below the active layer ACT of the transistor T may be connected to the source electrode SE of the transistor T through a first contact hole CNT1 penetrating the first passivation layer PRL1, the first insulating layer IL1, and the second insulating layer IL2. Alternatively, the transistor T may be a switching transistor (e.g., one of the second to fifth transistors T2 to T5 in FIG. 3) of the pixel PX, and the first bottom electrode BE1 disposed below the active layer ACT of the transistor T may be connected to the gate electrode GE of the transistor T. Each of the switching transistors of the pixel PX may or may not include the first bottom electrode BE1 disposed therebelow.

The active layer ACT may be provided in the semiconductor layer SCL. The semiconductor layer SCL may be disposed on the first insulating layer IL1 covering the first bottom conductive layer BCDL1 and the like, and may be covered by the gate insulating layer GI and the second insulating layer IL2.

The active layer ACT may include the channel region CH, and the source region SR and the drain region DR spaced apart from each other with the channel region CH interposed therebetween. For example, the source region SR and the drain region DR may be located on both sides of the channel region CH. The source region SR and the drain region DR may be conductive regions to have a carrier concentration (for example, electron concentration) higher than that of the channel region CH.

The active layer ACT may overlap the first bottom electrode BE1 and the gate electrode GE. For example, a part of the active layer ACT including the channel region CH may overlap the first bottom electrode BE1 and the gate electrode GE.

In one embodiment, the active layer ACT may include an oxide semiconductor. For example, the active layer ACT may include an oxide semiconductor containing at least one of indium (In), gallium (Ga), zinc (Zn), tin (Sn), and hafnium (Hf), or other oxide semiconductors.

In one embodiment, the active layer ACT may include at least one of zinc oxide (ZnO), zinc-tin oxide (ZTO), indium-zinc oxide (IZO), indium oxide (InO or In₂O₃), titanium oxide (TiO or TiO₂), indium-gallium oxide (IGO), indium-gallium-zinc oxide (IGZO), indium-gallium-tin oxide (IGTO), indium-zinc-tin oxide (IZTO), or indium-tin-gallium-zinc oxide (ITGZO), or other oxide semiconductors. For example, the active layer ACT may include indium-gallium-zinc oxide (IGZO) or may include a high mobility oxide semiconductor, e.g., indium-tin-gallium-zinc oxide (ITGZO) or indium-gallium oxide (IGO) (e.g., crystallized IGO), with higher mobility than indium-gallium-zinc oxide (IGZO) (e.g., amorphous IGZO). When the active layer ACT is formed of a high-mobility oxide semiconductor, the conductivity of the source region SR and the drain region DR may be appropriately and/or easily secured without performing an additional doping process. Further, when the active layer ACT is formed of a high-mobility oxide semiconductor, it is possible to form the transistor T in a fine size (e.g., a size including the active layer ACT having a width and/or length within a range of approximately several micrometers to several tens of micrometers) and appropriately secure the mobility of the transistor T. The material, crystallinity, and mobility of the active layer ACT are not limited and may vary according to embodiments.

The first gate insulating layer GI1 may be disposed on the active layer ACT. For example, the first gate insulating layer GI1 may be disposed between the active layer ACT and the gate electrode GE.

In one embodiment, the first gate insulating layer GI1 may cover a portion of the active layer ACT, including a portion overlapping the gate electrode GE, and expose another portion of the active layer ACT. For example, the first gate insulating layer GI1 may be disposed on a part of the active layer ACT including the channel region CH, and may expose the source region SR and the drain region DR of the active layer ACT.

Since the first gate insulating layer GI1 exposes the source region SR and the drain region DR, the source region SR and the drain region DR may become appropriately and/or easily conductive in the manufacturing process of the display panel 110. For example, in the step of etching the gate insulating layer GI to expose at least a part of the source region SR and at least a part of the drain region DR, oxygen vacancies may occur in the source region SR and the drain region DR by an etching gas or the like. Accordingly, the source region SR and the drain region DR may be appropriately conductive in a subsequent process (e.g., a process of forming the second insulating layer IL2) without performing a separate doping process.

A gate electrode GE may be disposed on the first gate insulating layer GI1. The gate electrode GE may be provided in the first conductive layer CDL1. The first conductive layer CDL1 may be disposed on the first insulating layer IL1 and the gate insulating layer GI, and may be covered by the second insulating layer IL2. Each of the patterns of the first conductive layer CDL1 may be formed as a single layer (e.g., a single metal layer), or as multiple layers of double or more layers (e.g., metal layers of double or more layers).

The gate electrode GE may be disposed on the active layer ACT. For example, the gate electrode GE may be disposed on the first gate insulating layer GI1 covering the channel region CH of the active layer ACT. The gate electrode GE and the active layer ACT may be separated and/or spaced apart from each other with the first gate insulating layer GI1 interposed therebetween.

The second insulating layer IL2 may be disposed on the gate electrode GE. The second insulating layer IL2 may cover the active layer ACT, the gate insulating layer GI, and the gate electrode GE.

The source electrode SE and the drain electrode DE may be disposed on the second insulating layer IL2. The source electrode SE and the drain electrode DE may be provided in the second conductive layer CDL2. The second conductive layer CDL2 may be disposed between the second insulating layer IL2 and the third insulating layer IL3. In one embodiment, each of the patterns of the second conductive layer CDL2 may be formed as a single layer (e.g., a single metal layer). Alternatively, each of the patterns of the second conductive layer CDL2 may be formed as multiple layers of double or more layers (e.g., metal layers of double or more layers). In one example, each of the patterns of the second conductive layer CDL2 may be formed as a double layer or triple layer including a low resistance metal layer made of aluminium (Al) or copper (Cu) (or at least one of aluminium (Al) and copper (Cu)), or the like, and an upper capping layer and/or a lower capping layer disposed above and/or below the low resistance metal layer and containing a capping metal such as titanium (Ti).

The source electrode SE may be connected to a part of the active layer ACT. For example, the source electrode SE may be electrically connected to the source region SR of the active layer ACT through a second contact hole CNT2 penetrating the second insulating layer IL2. In one embodiment, the source electrode SE may be electrically connected to the first bottom electrode BE1 through the first contact hole CNT1.

The drain electrode DE may be connected to another part of the active layer ACT. For example, the drain electrode DE may be connected to the drain region DR of the active layer ACT through a third contact hole CNT3 penetrating the second insulating layer IL2.

In one embodiment, at least one transistor T provided in each pixel area PXA may be electrically connected to the light emitting element ED disposed on the transistor T. For example, at least one transistor T (e.g., the first transistor T1) provided in each pixel area PXA may be connected to the bridge electrode BRE disposed on the third insulating layer IL3 covering the second conductive layer CDL2. For example, the source electrode SE (or the drain electrode DE) of the first transistor T1 provided in each pixel area PXA may be connected to the bridge electrode BRE through a sixth contact hole CNT6 penetrating the third insulating layer IL3. The at least one transistor T may be connected to the light emitting element ED disposed on the fourth insulating layer IL4 through the bridge electrode BRE.

The bridge electrode BRE may be provided in the third conductive layer CDL3. The bridge electrode BRE may be connected to a first electrode ET1 of the light emitting element ED provided in the light emitting element layer LEL through an eighth contact hole CNT8 penetrating the fourth insulating layer IL4.

The third conductive layer CDL3 may be disposed between the third insulating layer IL3 and the fourth insulating layer IL4. For example, the third conductive layer CDL3 may be disposed on the third insulating layer IL3 and covered by the fourth insulating layer IL4. In one embodiment, each of the patterns of the third conductive layer CDL3 may be formed as a single layer (e.g., a single metal layer). Alternatively, each of the patterns of the third conductive layer CDL3 may be formed as multiple layers of double or more layers (e.g., metal layers of double or more layers). In one example, each of the patterns of the third conductive layer CDL3 may be formed as a double layer or triple layer including a low resistance metal layer containing aluminium (Al) or copper (Cu), or the like, and an upper capping layer and/or a lower capping layer disposed above and/or below the low resistance metal layer and containing a capping metal such as titanium (Ti).

The capacitor C may include capacitor electrodes that form a capacitance. For example, the first capacitor C1 of FIG. 3 may include the first capacitor electrode CE1 and the second capacitor electrode CE2.

In one embodiment, the first capacitor C1 may have a multilayer structure including a multilayer electrode. For example, the first capacitor electrode CE1 may include the first sub-electrode CE1a provided in the first conductive layer CDL1, and the second sub-electrode CE1b provided in the second conductive layer CDL2. The first sub-electrode CE1a and the second sub-electrode CE1b of the first capacitor electrode CE1 may be electrically connected to each other through a fourth contact hole CNT4 penetrating the second insulating layer IL2. The second capacitor electrode CE2 may include the first sub-electrode CE2a provided in the first bottom conductive layer BCDL1, and the second sub-electrode CE2b provided in the second conductive layer CDL2. In one embodiment, the second capacitor electrode CE2 may further include the third sub-electrode CE2c provided in the third conductive layer CDL3. The first sub-electrode CE2a and the second sub-electrode CE2b of the second capacitor electrode CE2 may be electrically connected to each other through a fifth contact hole CNT5 penetrating the first passivation layer PRL1, the first insulating layer IL1, and the second insulating layer IL2. The second sub-electrode CE2b and the third sub-electrode CE2c of the second capacitor electrode CE2 may be electrically connected to each other through a seventh contact hole CNT7 penetrating the third insulating layer IL3. By forming the first capacitor C1 in a multilayer structure, the capacity of the first capacitor C1 may be adequately secured by efficiently utilizing the pixel area PXA of limited size.

The structure of the first capacitor C1 may be variously modified according to embodiments. For example, the structure and location of each of the first capacitor electrode CE1 and the second capacitor electrode CE2 may be variously modified according to embodiments.

In one embodiment, the first capacitor electrode CE1 may be connected to the gate electrode GE of the first transistor T1 located in each pixel area PXA. For example, the first sub-electrode CE1a of the first capacitor electrode CE1 may be provided in the first conductive layer CDL1 integrally with the gate electrode GE of the first transistor T1. For example, the first sub-electrode CE1a of the first capacitor electrode CE1 and the gate electrode GE of the first transistor T1 may be connected to each other to form an integrated electrode when viewed on a plane (e.g., when viewed on a plane defined by the first direction D1 and the second direction D2). In this case, the first gate insulating layer GI1 located under the gate electrode GE of the first transistor T1 and the second gate insulating layer GI2 located under the first sub-electrode CE1a of the first capacitor electrode CE1 may be connected to each other to form an integrated insulating pattern.

In one embodiment, the second capacitor electrode CE2 may be connected to the source electrode SE of the first transistor T1 located in each pixel area PXA. For example, the first sub-electrode CE2a of the second capacitor electrode CE2 may be provided to the first bottom conductive layer BCDL1 integrally with the first bottom electrode BE1 of the first transistor T1, and may be connected to the source electrode SE of the first transistor T1 through the first contact hole CNT1. The second sub-electrode CE2b of the second capacitor electrode CE2 may be formed integrally with the source electrode SE of the first transistor T1 located in each pixel area PXA, or may be formed separately from the source electrode SE. The third sub-electrode CE2c of the second capacitor electrode CE2 may be formed integrally with the bridge electrode BRE located in each pixel area PXA, or may be formed separately from the bridge electrode BRE.

The light emitting element layer LEL may be disposed on the panel circuit layer PCL. For example, the light emitting element layer LEL may be disposed on the fourth insulating layer IL4, and may be located at least in the display area DA.

The light emitting element layer LEL may include the light emitting element ED for each of the pixels PX. For example, the light emitting element layer LEL may include a pixel defining layer PDL (also referred to as "bank") that partitions the emission areas of the pixels PX and the light emitting element ED located in each emission area. In one embodiment, the light emitting element layer LEL may further include a spacer SPC disposed on a part of the pixel defining layer PDL.

Each light emitting element ED may include a first electrode ET1 located in each emission area, and a light emitting layer EML and a second electrode ET2 sequentially disposed on the first electrode ET1. The first electrode ET1 of the light emitting element ED may be connected to at least one transistor (e.g., the first transistor T1) included in the corresponding pixel PX.

The first electrode ET1 of the light emitting element ED may be a single-layer or multi-layer electrode including at least one conductive material. In one embodiment, the display panel 110 may be a top emission type display panel, and the first electrode ET1 may include a reflective electrode layer having high reflectivity.

The light emitting layer EML of the light emitting element ED may include a polymer material or a low molecular material. Light emitted from the light emitting layer EML may contribute to image display.

The second electrode ET2 of the light emitting element ED may include a conductive material. In one embodiment, the second electrode ET2 may be a common layer formed across the entire display area DA to cover the light emitting layer EML and the pixel defining layer PDL. In one embodiment, the display panel 110 may be a top emission type display panel, and the second electrode ET2 may include a transparent or translucent electrode layer.

The pixel defining layer PDL may have an opening corresponding to each emission area and may surround the emission area. For example, the pixel defining layer PDL may be formed to cover an edge of the first electrode ET1 of the light emitting element ED and may include an opening exposing the remaining portion of the first electrode ET1. A region where the exposed first electrode ET1 and the light emitting layer EML overlap may be the emission area of each pixel PX. In one embodiment, the pixel defining layer PDL may include at least one organic insulating layer containing an organic insulating material.

The spacer SPC may be disposed on a part of the pixel defining layer PDL. The spacer SPC may include at least one organic insulating layer containing an organic insulating material. The spacer SPC may include the same material as the pixel defining layer PDL or may include a different material from the pixel defining layer PDL. The pixel defining layer PDL and the spacer SPC may be sequentially formed through individual mask processes, or may be simultaneously and/or integrally formed using a halftone mask.

The encapsulation layer ENL may be disposed on the light emitting element layer LEL. The encapsulation layer ENL may cover the light emitting element layer LEL in the display area DA and may extend to the non-display area NDA to be in contact with the panel circuit layer PCL. The encapsulation layer ENL may block the permeation of oxygen or moisture into the light emitting element layer LEL, and may reduce electrical and/or physical impacts to the panel circuit layer PCL and the light emitting element layer LEL.

In one embodiment, the encapsulation layer ENL may include a first encapsulation layer ENL1, a second encapsulation layer ENL2, and a third encapsulation layer ENL3 sequentially disposed on the light emitting element layer LEL. Each of the first encapsulation layer ENL1 and the third encapsulation layer ENL3 may be an inorganic encapsulation layer containing an inorganic material. The second encapsulation layer ENL2 may be an organic encapsulation layer containing an organic material.

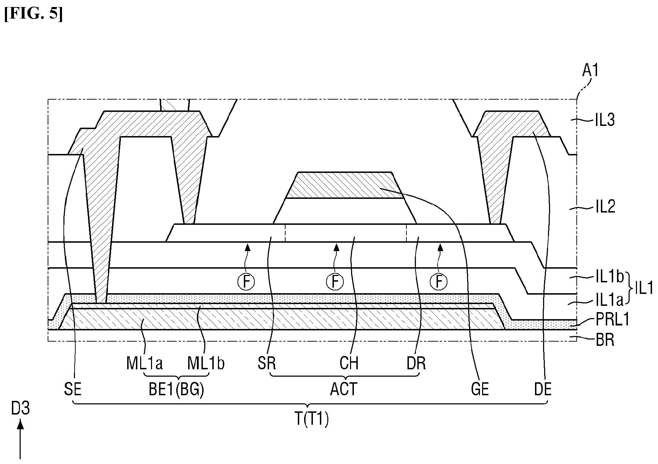

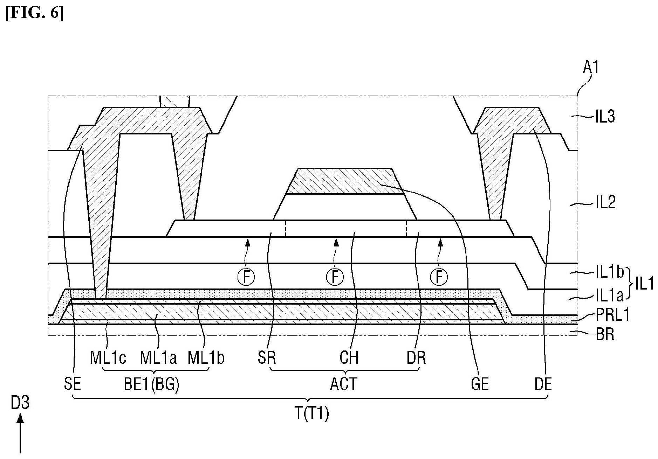

FIG. 5 is a cross-sectional view showing area A1 of FIG. 4 in detail. FIG. 6 is a cross-sectional view showing area A1 of FIG. 4 in detail. For example, FIGS. 5 and 6 are enlarged views showing the transistor T of FIG. 4 in detail, and illustrate different embodiments with respect to the first bottom electrode BE1 disposed below the active layer ACT of the transistor T.

Referring to FIGS. 5 and 6 in addition to FIG. 4, the first bottom electrode BE1 may be formed as at least a double-layer electrode. For example, as shown in FIG. 5, the first bottom electrode BE1 may be formed as a double-layer electrode including a first metal layer ML1a and a second metal layer ML1b disposed on the first metal layer ML1a. Alternatively, as shown in FIG. 6, the first bottom electrode BE1 may be formed as a triple-layer electrode including the first metal layer ML1a, the second metal layer ML1b disposed on the first metal layer ML1a, and a third metal layer ML1c disposed below the first metal layer ML1a.

In one embodiment, the first metal layer ML1a may include a low resistance metal having a relatively low resistance. For example, the first metal layer ML1a may include aluminium (Al) or copper (Cu). The first metal layer ML1a may include another low resistance metal other than aluminium (Al) or copper (Cu). The first metal layer ML1a may have a relatively large thickness compared to the second metal layer ML1b or the third metal layer ML1c. Accordingly, the resistance of the electrodes including the first bottom electrode BE1, conductive patterns, and/or wires provided in the first bottom conductive layer BCDL1 may be reduced, and the response speed of the transistor T and the pixel PX including it may be improved.

In one embodiment, each of the second metal layer ML1b and the third metal layer ML1c may include a capping metal that can block ions of the first metal layer ML1a from diffusing to the surroundings. For example, each of the second metal layer ML1b and the third metal layer ML1c may include titanium (Ti). Each of the second metal layer ML1b and the third metal layer ML1c may include a capping metal other than titanium (Ti).

The second metal layer ML1b may cover the top surface of the first metal layer ML1a. The third metal layer ML1c may cover the bottom surface of the first metal layer ML1a. Accordingly, it is possible to suppress the occurrence of voids or seams in or around the first metal layer ML1a and to block the diffusion of hydrogen in the third direction D3 and the like.

In one embodiment, the second metal layer ML1b and the third metal layer ML1c may not be provided on the side surface (or at least a portion of the side surface) of the first metal layer ML1a. For example, the second metal layer ML1b and the third metal layer ML1c may expose the side surface of the first metal layer ML1a.

In embodiments, the exposed side surface (e.g., an inclined surface not covered by the second metal layer ML1b and the third metal layer ML1c) of the first metal layer ML1a may be covered by the first passivation layer PRL1. Accordingly, the first metal layer ML1a may be adequately protected from moisture, chemical solutions used in the manufacturing process of the display panel 110, or the like. For example, even if the first metal layer ML1a is formed of a low-resistance metal that is relatively susceptible to corrosion, corrosion of the first metal layer ML1a may be prevented by covering the exposed side surface of the first metal layer ML1a with the first passivation layer PRL1.

In embodiments, the first passivation layer PRL1 may contain the previously exemplified materials (e.g., at least one of silicon nitride (SiNₓ), silicon oxide (SiOₓ), and silicon oxynitride (SiON), and the first additive such as fluorine (F), chlorine (Cl), carbon (C), or sulfur (S)). In one embodiment, the first passivation layer PRL1 may contain fluorine (F)-doped silicon nitride (SiNₓ:F). Accordingly, the characteristics of the transistor T may be improved while adequately protecting the first metal layer ML1a and the first bottom electrode BE1 including it.

When the first passivation layer PRL1 containing fluorine (F) is disposed below the active layer ACT, fluorine (F) may enter or diffuse into the active layer ACT. The fluorine (F) diffused into the active layer ACT may reduce oxygen vacancies in the active layer ACT by taking the place of oxygen vacancies existing in the active layer ACT. Accordingly, deviations in the characteristics, such as threshold voltage distribution, of the transistor T may be reduced. In one embodiment, the active layer ACT may be formed of a high mobility oxide semiconductor, such as indium-tin-gallium-zinc oxide (ITGZO) or indium-gallium oxide (IGO), and the oxygen vacancies in the active layer ACT may be reduced due to the diffusion of fluorine (F), thereby effectively improving (e.g., uniformizing and/or stabilizing) the characteristics of the transistor T and the pixel PX including it.

Further, as fluorine (F) diffuses into the active layer ACT, additional carriers may be generated. For example, fluorine (F) diffused into the active layer ACT may react with zinc-oxide (ZnO) and the like (e.g., by substitution between oxygen and fluorine) to generate electrons that are carriers. Accordingly, traps (e.g., traps formed in a back-channel region adjacent to the first bottom electrode BE1) in the active layer ACT may be reduced, and reliability (e.g., positive bias temperature stress (PBTS) characteristics) of the transistor T may be improved. In one embodiment, the active layer ACT may be formed of an oxide semiconductor such as indium-gallium-zinc oxide (IGZO), and the carriers in the active layer ACT may be increased due to the diffusion of fluorine (F), thereby effectively improving the characteristics (e.g., response speed and the like) of the transistor T and the pixel PX including it.

In one embodiment, the thickness of the first passivation layer PRL1 may be 100 Å or less. Accordingly, the amount of fluorine (F) or the like that diffuses from the first passivation layer PRL1 to the active layer ACT may be appropriately limited to prevent excessive changes in the characteristics of the transistor T.

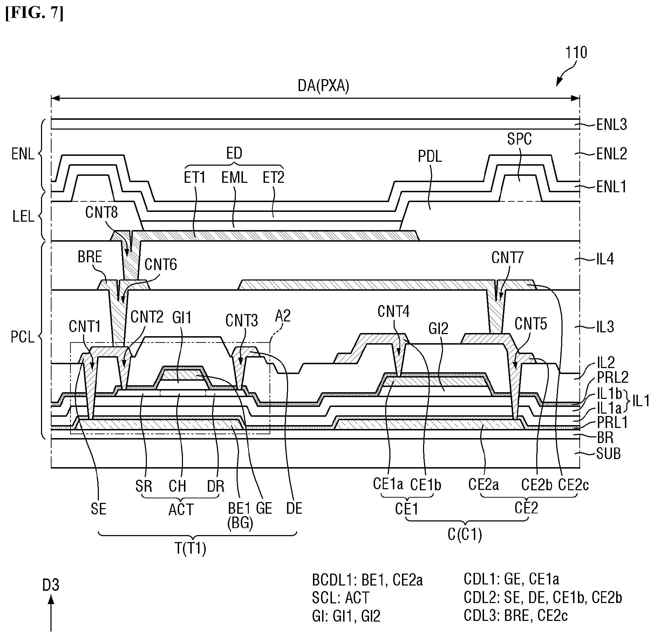

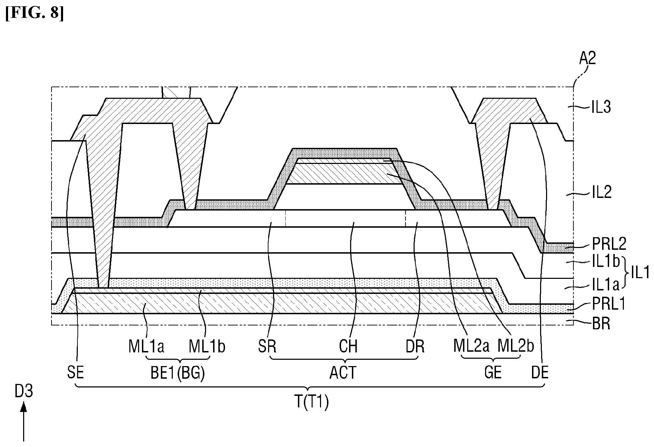

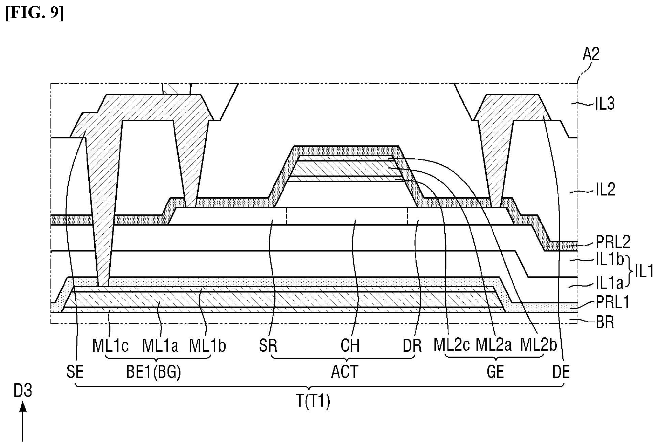

FIG. 7 is a cross-sectional view illustrating the display panel 110 according to one embodiment. FIG. 8 is a cross-sectional view showing area A2 of FIG. 7 in detail. FIG. 9 is a cross-sectional view showing area A2 of FIG. 7 in detail. For example, FIGS. 8 and 9 are enlarged views showing the transistor T of FIG. 7 in detail, and illustrate different embodiments with respect to the gate electrode GE. Compared to the embodiments of FIGS. 4 to 6, FIGS. 7 to 9 show the display panel 110 that further includes a second passivation layer PRL2.

Referring to FIGS. 7 to 9, the gate electrode GE may be formed as at least a double-layer electrode. In one embodiment, as shown in FIG. 8, the gate electrode GE may be formed as a double-layer electrode including a fourth metal layer ML2a (or a first metal layer of the gate electrode GE) and a fifth metal layer ML2b (or a second metal layer of the gate electrode GE) disposed on the fourth metal layer ML2a. Alternatively, as shown in FIG. 9, the gate electrode GE may be formed as a triple layer electrode including the fourth metal layer ML2a, the fifth metal layer ML2b disposed on the fourth metal layer ML2a, and a sixth metal layer ML2c (or a third metal layer of the gate electrode GE) disposed below the fourth metal layer ML2a.

In one embodiment, the fourth metal layer ML2a may include a low resistance metal having a relatively low resistance. For example, the fourth metal layer ML2a may include aluminium (Al) or copper (Cu). The fourth metal layer ML2a may include another low resistance metal other than aluminium (Al) or copper (Cu). The fourth metal layer ML2a may have a relatively large thickness compared to the fifth metal layer ML2b or the sixth metal layer ML2c. Accordingly, the resistance of the electrodes including the gate electrode GE, conductive patterns, and/or wires provided in the first conductive layer CDL1 may be reduced, and the response speed of the transistor T and the pixel PX including it may be improved.

In one embodiment, each of the fifth metal layer ML2b and the sixth metal layer ML2c may include a capping metal that can block ions of the fourth metal layer ML2a from diffusing to the surroundings. For example, each of the fifth metal layer ML2b and the sixth metal layer ML2c may include titanium (Ti). Each of the fifth metal layer ML2b and the sixth metal layer ML2c may include a capping metal other than titanium (Ti).

The fifth metal layer ML2b may cover the top surface of the fourth metal layer ML2a. The sixth metal layer ML2c may cover the bottom surface of the fourth metal layer ML2a. Accordingly, it is possible to suppress the occurrence of voids or seams in or around the fourth metal layer ML2a and to block the diffusion of hydrogen in the third direction D3 and the like.

In one embodiment, the fifth metal layer ML2b and the sixth metal layer ML2c may not be provided on the side surface (or at least a portion of the side surface) of the fourth metal layer ML2a. For example, the fifth metal layer ML2b and the sixth metal layer ML2c may expose the side surface of the fourth metal layer ML2a.

In embodiments, the exposed side surface of the fourth metal layer ML2a may be covered by the second passivation layer PRL2. For example, the display panel 110 may further include the second passivation layer PRL2. Accordingly, the fourth metal layer ML2a may be adequately protected. For example, even if the fourth metal layer ML2a is formed of a low resistance metal that is relatively susceptible to corrosion, corrosion of the fourth metal layer ML2a may be prevented by covering the exposed side surface (e.g., an inclined surface not covered by the fifth metal layer ML2b and the sixth metal layer ML2c) of the fourth metal layer ML2a with the second passivation layer PRL2.

The second passivation layer PRL2 may be disposed between the first conductive layer CDL1 and the second insulating layer IL2. For example, the second passivation layer PRL2 may be disposed on the first insulating layer IL1, the semiconductor layer SCL, the gate insulating layer GI, and the first conductive layer CDL1 to cover the patterns of the semiconductor layer SCL, the gate insulating layer GI, and the first conductive layer CDL1. In one example, the second passivation layer PRL2 may cover the gate electrode GE of the transistor T, the first sub-electrode CE1a of the first capacitor electrode CE1, and the like.

The second passivation layer PRL2 may contain a material that can adequately protect the patterns of the first conductive layer CDL1 from moisture, chemical solutions used in the manufacturing process of the display panel 110, or the like. In one embodiment, the second passivation layer PRL2 may contain silicon oxide (SiOₓ) or silicon oxynitride (SiON), and a second additive (or second material) added to the silicon oxide (SiOₓ) or silicon oxynitride (SiON). By forming the second passivation layer PRL2 with silicon oxide (SiOₓ) or silicon oxynitride (SiON), diffusion of hydrogen from the second passivation layer PRL2 to the active layer ACT may be prevented or reduced.

In one embodiment, the second additive may contain at least one of fluorine (F), chlorine (Cl), carbon (C), and sulfur (S). For example, the second passivation layer PRL2 may contain fluorine (F)-doped silicon oxide (SiOₓ:F) or silicon oxynitride (SiON:F), chlorine (Cl)-doped silicon oxide (SiOₓ:Cl) or silicon oxynitride (SiON:Cl), carbon (C)-doped silicon oxide (SiOₓ:C) or silicon oxynitride (SiON:C), or sulfur (S)-doped silicon oxide (SiOₓ:S) or silicon oxynitride (SiON:S). The concentration of the second additive, e.g., fluorine (F), chlorine (Cl), carbon (C), or sulfur (S), contained in the second passivation layer PRL2 may be equal to or greater than 2.5 times the concentration of fluorine (F), chlorine (Cl), carbon (C), or sulfur (S) contained in the second insulating layer IL2 (or a lower layer of the second insulating layer IL2) on the second passivation layer PRL2.

In one embodiment, the second passivation layer PRL2 may contain fluorine (F)-doped silicon oxide (SiOₓ:F) or silicon oxynitride (SiON:F). Accordingly, the characteristics of the transistor T may be improved while adequately protecting the fourth metal layer ML2a and the first conductive layer CDL1 including it. For example, the fluorine (F) in the second passivation layer PRL2 may enter or diffuse into the active layer ACT, thereby reducing oxygen vacancies in the active layer ACT. In addition, the fluorine (F) that has entered or diffused into the active layer ACT may generate carriers (e.g., electrons). Accordingly, deviations in the characteristics of the transistor T may be prevented or reduced, and the reliability and operating characteristics of the transistor T may be improved.

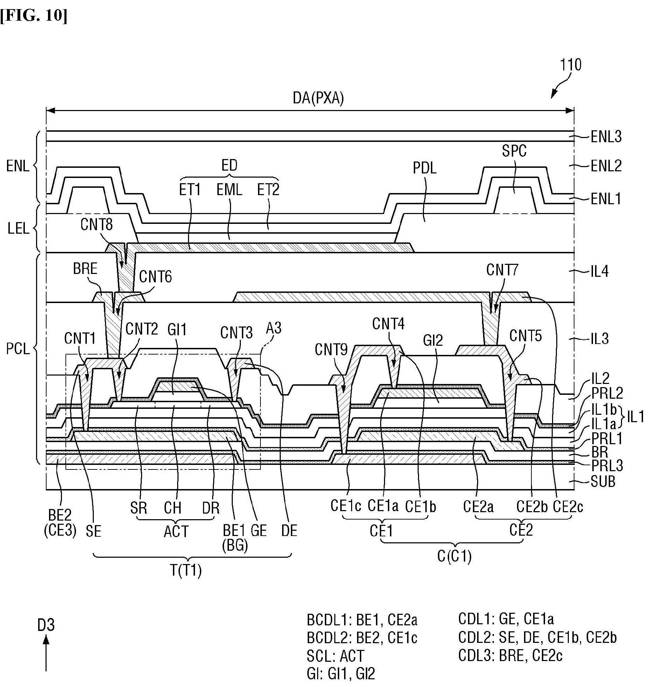

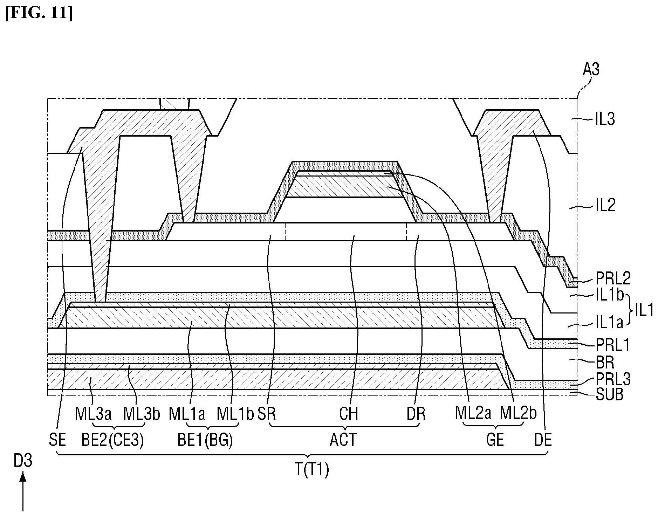

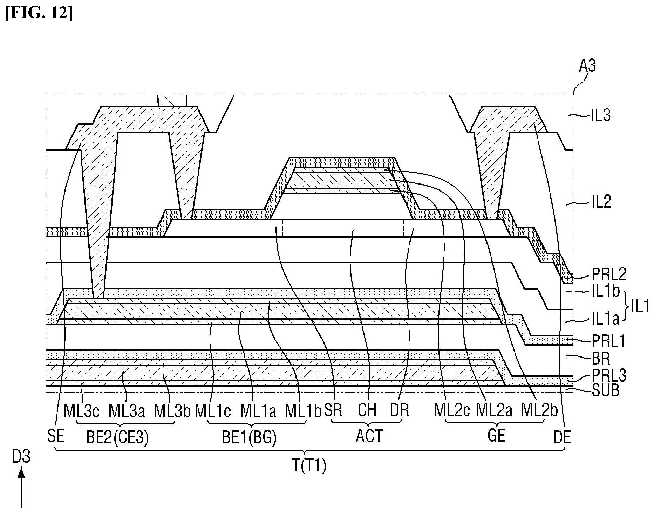

FIG. 10 is a cross-sectional view illustrating the display panel 110 according to one embodiment. FIG. 11 is a cross-sectional view showing area A3 of FIG. 10 in detail. FIG. 12 is a cross-sectional view showing area A3 of FIG. 10 in detail. For example, FIGS. 11 and 12 illustrate different embodiments with respect to the first bottom electrode BE1 and a second bottom electrode BE2. Compared to the previously described embodiments (e.g., the embodiments of FIGS. 4 to 6 or the embodiments of FIGS. 7 to 9), FIGS. 10 to 12 show the display panel 110 that further includes a second bottom conductive layer BCDL2 and a third passivation layer PRL3.

Referring to FIGS. 10 to 12, the display panel 110 may further include the second bottom conductive layer BCDL2 and the third passivation layer PRL3 disposed between the substrate SUB and the barrier layer BR.

The second bottom conductive layer BCDL2 (also referred to as "second lower conductive layer" or "fifth conductive layer") may include the second bottom electrode BE2 disposed below the transistor T. In one example, the second bottom conductive layer BCDL2 may further include the second bottom electrode BE2 disposed below the first bottom electrode BE1. In one embodiment, the second bottom conductive layer BCDL2 may further include a third sub-electrode CE1c of the first capacitor electrode CE1.

The second bottom electrode BE2 may overlap the first bottom electrode BE1. Accordingly, a capacitor (e.g., the second capacitor C2 of FIG. 3) may be formed between the second bottom electrode BE2 and the first bottom electrode BE1. For example, the second bottom electrode BE2 may constitute a third capacitor electrode CE3, and the first bottom electrode BE1 may constitute a fourth capacitor electrode. The third capacitor electrode CE3 and the fourth capacitor electrode may form the second capacitor C2 of FIG. 3. Alternatively, the second bottom electrode BE2 may be integrally formed with the third sub-electrode CE1c of the first capacitor electrode CE1 to form the first capacitor C1.

The third sub-electrode CE1c of the first capacitor electrode CE1 may overlap at least one sub-electrode (e.g., the first sub-electrode CE2a of the second capacitor electrode CE2) forming the second capacitor electrode CE2. The third sub-electrode CE1c of the first capacitor electrode CE1 may be connected to at least one of the first sub-electrode CE1a or the second sub-electrode CE1b of the first capacitor electrode CE1. For example, the third sub-electrode CE1c of the first capacitor electrode CE1 may be electrically connected to the second sub-electrode CE1b of the first capacitor electrode CE1 through a ninth contact hole CNT9 penetrating the second insulating layer IL2, the second passivation layer PRL2, the first insulating layer IL1, the first passivation layer PRL1, the barrier layer BR, and the third passivation layer PRL3.

For example, the electrodes, the conductive patterns, and/or the wires provided or disposed in the second bottom conductive layer BCDL2 may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), and other metals, an alloy thereof, or another conductive material. Electrodes, conductive patterns, and/or wires provided or disposed in the second bottom conductive layer BCDL2 may be formed as a single layer or multiple layers.

In one embodiment, the electrodes, conductive patterns, and/or wires provided or disposed in the second bottom conductive layer BCDL2 may be formed as at least a double layer. For example, as shown in FIG. 11, the second bottom electrode BE2 may be formed as a double-layer electrode including a seventh metal layer ML3a (or a first metal layer of the second bottom electrode BE2) and an eighth metal layer ML3b (or a second metal layer of the second bottom electrode BE2) disposed on the seventh metal layer ML3a. Alternatively, as shown in FIG. 12, the second bottom electrode BE2 may be formed as a triple-layer electrode including the seventh metal layer ML3a, the eighth metal layer ML3b disposed on the seventh metal layer ML3a, and a ninth metal layer ML3c (or a third metal layer of the second bottom electrode BE2) disposed below the seventh metal layer ML3a.

In one embodiment, the seventh metal layer ML3a may include a low resistance metal having a relatively low resistance. For example, the seventh metal layer ML3a may include aluminium (Al) or copper (Cu). The seventh metal layer ML3a may include another low resistance metal other than aluminium (Al) or copper (Cu). The seventh metal layer ML3a may have a relatively large thickness compared to the eighth metal layer ML3b or the ninth metal layer ML3c. Accordingly, the resistance of the electrodes including the second bottom electrode BE2, conductive patterns, and/or wires provided in the second bottom conductive layer BCDL2 may be reduced.

In one embodiment, each of the eighth metal layer ML3b and the ninth metal layer ML3c may include a capping metal that can block ions of the seventh metal layer ML3a from diffusing to the surroundings. For example, each of the eighth metal layer ML3b and the ninth metal layer ML3c may include titanium (Ti). Each of the eighth metal layer ML3b and the ninth metal layer ML3c may include a capping metal other than titanium (Ti).

The eighth metal layer ML3b may cover the top surface of the seventh metal layer ML3a. The ninth metal layer ML3c may cover the bottom surface of the seventh metal layer ML3a. Accordingly, it is possible to suppress the occurrence of voids or seams in or around the seventh metal layer ML3a and to block the diffusion of hydrogen in the third direction D3 and the like.

In one embodiment, the eighth metal layer ML3b and the ninth metal layer ML3c may not be provided on the side surface (or at least a portion of the side surface) of the seventh metal layer ML3a. For example, the eighth metal layer ML3b and the ninth metal layer ML3c may expose the side surface of the seventh metal layer ML3a.

In embodiments, the exposed side surface of the seventh metal layer ML3a may be covered by the third passivation layer PRL3. For example, the display panel 110 may further include the third passivation layer PRL3. Accordingly, the seventh metal layer ML3a may be adequately protected. For example, even if the seventh metal layer ML3a is formed of a low resistance metal that is relatively susceptible to corrosion, corrosion of the seventh metal layer ML3a may be prevented by covering the exposed side surface (e.g., an inclined surface not covered by the eighth metal layer ML3b and the ninth metal layer ML3c) of the seventh metal layer ML3a with the third passivation layer PRL3.

The third passivation layer PRL3 may be disposed between the second bottom conductive layer BCDL1 and the barrier layer BR. For example, the third passivation layer PRL3 may be disposed on the substrate SUB and the second bottom conductive layer BCDL2 to cover the patterns of the second bottom conductive layer BCDL2. In one example, the third passivation layer PRL3 may cover the second bottom electrode BE2, the third sub-electrode CE1c of the first capacitor electrode CE1, and the like.

The third passivation layer PRL3 may contain a material that can adequately protect the patterns of the second bottom conductive layer BCDL2 from moisture, chemical solutions used in the manufacturing process of the display panel 110, or the like. In one embodiment, the third passivation layer PRL3 may contain at least one of silicon nitride (SiNₓ), silicon oxide (SiOₓ), and silicon oxynitride (SiON), and a third additive (or third material) added thereto. In one embodiment, silicon nitride (SiNₓ) may be used to form the third passivation layer PRL3, thereby increasing the barrier effect of blocking the diffusion of moisture, hydrogen, or the like.

In one embodiment, the third additive may contain at least one of fluorine (F), chlorine (Cl), carbon (C), and sulfur (S). For example, the third passivation layer PRL3 may contain fluorine (F)-doped silicon nitride (SiNₓ:F), chlorine (Cl)-doped silicon nitride (SiNₓ:Cl), carbon (C)-doped silicon nitride (SiNₓ:C), sulfur (S)-doped silicon nitride (SiNₓ:S), fluorine (F)-doped silicon oxide (SiOₓ:F) or silicon oxynitride (SiON:F), chlorine (Cl)-doped silicon oxide (SiOₓ:Cl) or silicon oxynitride (SiON:Cl), carbon (C)-doped silicon oxide (SiOₓ:C) or silicon oxynitride (SiON:C), or sulfur (S)-doped silicon oxide (SiOₓ:S) or silicon oxynitride (SiON:S). The concentration of the third additive, e.g., fluorine (F), chlorine (Cl), carbon (C), or sulfur (S), contained in the third passivation layer PRL3 may be equal to or greater than 2.5 times the concentration of fluorine (F), chlorine (Cl), carbon (C), or sulfur (S) contained in the barrier layer BR (or a lower layer of the barrier layer BR) on the third passivation layer PRL3.

In one embodiment, the third passivation layer PRL3 may contain fluorine (F)-doped silicon nitride (SiNₓ:F). Accordingly, the characteristics of the transistor T may be improved while adequately protecting the seventh metal layer ML3a and the second bottom electrode BE2 including it. For example, the amount of fluorine (F) entering or diffusing into the active layer ACT may be increased by the third passivation layer PRL3 containing fluorine (F). Further, the fluorine (F) that has entered or diffused into the active layer ACT may reduce oxygen vacancies in the active layer ACT and generate carriers (e.g., electrons). Accordingly, deviations in the characteristics of the transistor T may be prevented or reduced, and the reliability and operating characteristics of the transistor T may be improved.

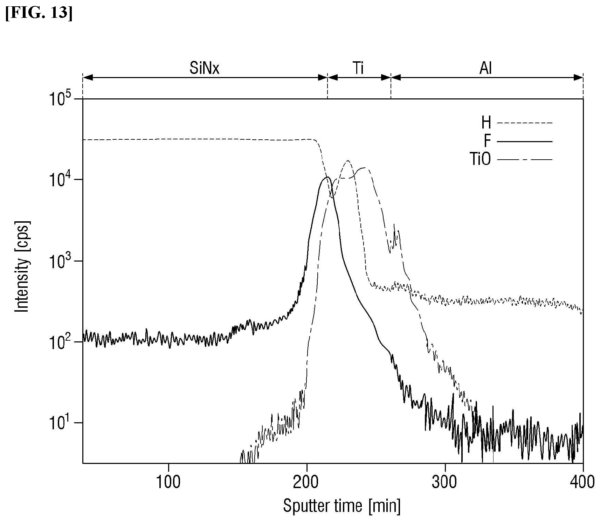

FIG. 13 is a graph showing a fluorine (F) concentration measured in the display panel 110 including the first passivation layer PRL1. For example, FIG. 13 shows the concentration of fluorine (F) and the like measured in the first passivation layer PRL1 and the surrounding layer of the first passivation layer PRL1 through secondary ion mass spectrometry (SIMS) analysis.

Referring to FIGS. 4 to 13, it can be seen that the fluorine (F) component sharply increases at the location where the first passivation layer PRL1 is provided, e.g., at the interface between the first layer IL1a of the first insulating layer IL containing silicon nitride (SiNₓ) and the second metal layer ML1b of the first bottom electrode BE1 containing titanium (Ti). For example, in the display panel 110 including the first passivation layer PRL1 to which fluorine (F) is added, the fluorine (F) concentration measured at the location where the first passivation layer PRL1 is provided may sharply increase compared to the fluorine (F) concentration in the surroundings. In one example, the fluorine (F) concentration measured at the location where the first passivation layer PRL1 is provided may be equal to or greater than 2.5 times the fluorine (F) concentration measured in the surroundings.

In one embodiment, the display panel 110 may further include at least one of the second passivation layer PRL2 or the third passivation layer PRL3. In this case, the fluorine (F) component may sharply increase even at locations where the second passivation layer PRL2 and/or the third passivation layer PRL3 are provided.

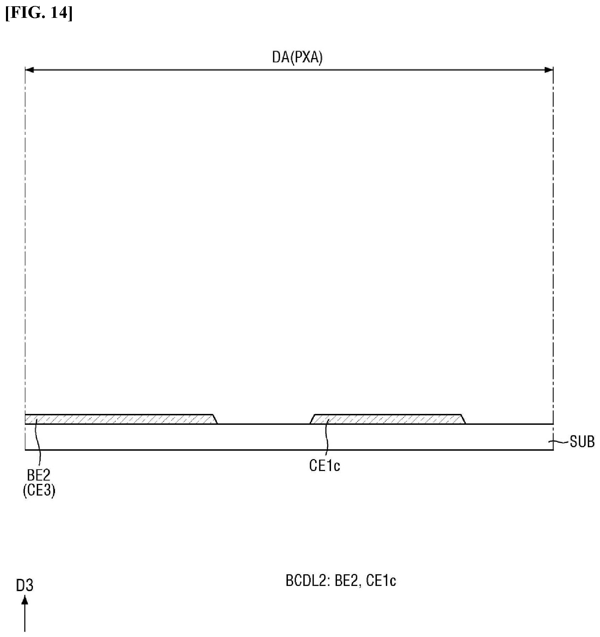

FIGS. 14 to 25 are cross-sectional views illustrating a method for manufacturing the display device 100 according to one embodiment. For example, FIGS. 14 to 25 sequentially show the steps of forming the panel circuit layer PCL among the steps of manufacturing the display panel 110 of FIG. 10.

Referring to FIG. 14, the substrate SUB including the display area DA may be provided. The display area DA may include the pixel area PXA.

Then, the second bottom conductive layer BCDL2 may be formed on the substrate SUB (or an additional barrier layer disposed on the substrate SUB). For example, the second bottom electrode BE2, the third sub-electrode CE1c of the first capacitor electrode CE1, and the like may be formed on the substrate SUB.

The patterns (e.g., the second bottom electrode BE2, and the third sub-electrode CE1c of the first capacitor electrode CE1) of the second bottom conductive layer BCDL2 may be formed by a film forming process (e.g., a deposition process) of a conductive layer that uses at least one conductive material exemplified above, and a patterning process (e.g., an etching process using a mask) of the conductive layer. In one embodiment, each of the patterns of the second bottom conductive layer BCDL2 may be formed, as shown in FIG. 11, as a double layer including the seventh metal layer ML3a and the eighth metal layer ML3b, or may be formed, as shown in FIG. 12, as a triple layer including the seventh metal layer ML3a, the eighth metal layer ML3b, and the ninth metal layer ML3c.

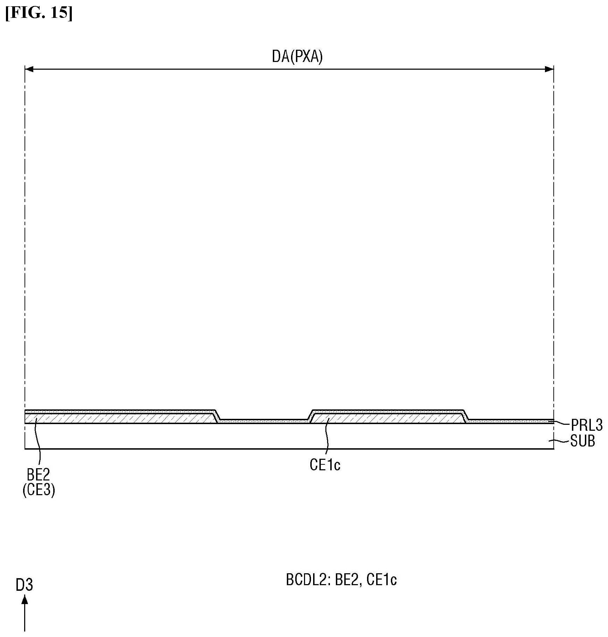

Referring to FIG. 15, the third passivation layer PRL3 covering the second bottom conductive layer BCDL2 may be formed on the substrate SUB. For example, the third passivation layer PRL3 may be formed on the patterns of the second bottom conductive layer BCDL2 including the second bottom electrode BE2 and the third sub-electrode CE1c of the first capacitor electrode CE1. The third passivation layer PRL3 may be formed by a film forming process of an insulating layer that uses the previously exemplified materials (e.g., at least one of silicon nitride (SiNₓ), silicon oxide (SiOₓ), and silicon oxynitride (SiON), and at least one of fluorine (F), chlorine (Cl), carbon (C), and sulfur (S)). The third passivation layer PRL3 may be formed to cover the side surface of the seventh metal layer ML3a that is not covered by the eighth metal layer ML3b, the ninth metal layer ML3c, and the like.

As in the embodiment of FIG. 4 or FIG. 7, when manufacturing the display panel 110 that does not include the second bottom conductive layer BCDL2 and the third passivation layer PRL3, the steps of forming the second bottom conductive layer BCDL2 and the third passivation layer PRL3 may be omitted.

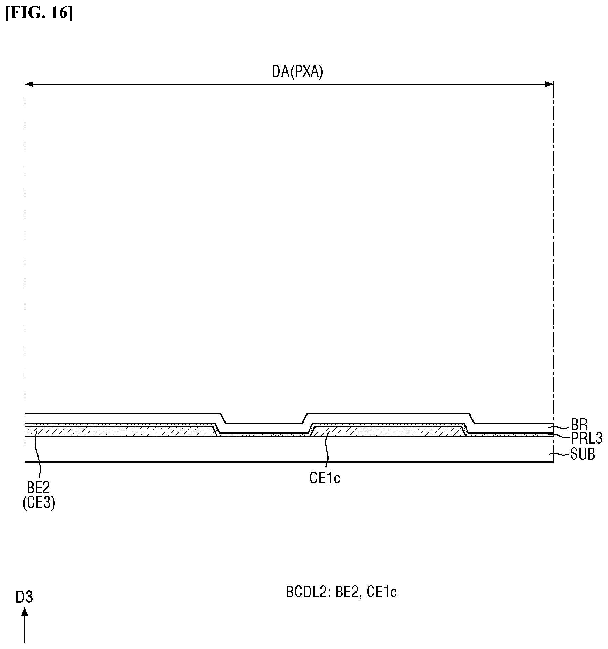

Referring to FIG. 16, the barrier layer BR may be formed on the third passivation layer PRL3 (or the substrate SUB). The barrier layer BR may be formed by a film forming process of an insulating layer that uses the previously exemplified insulating material (e.g., an inorganic insulating material).

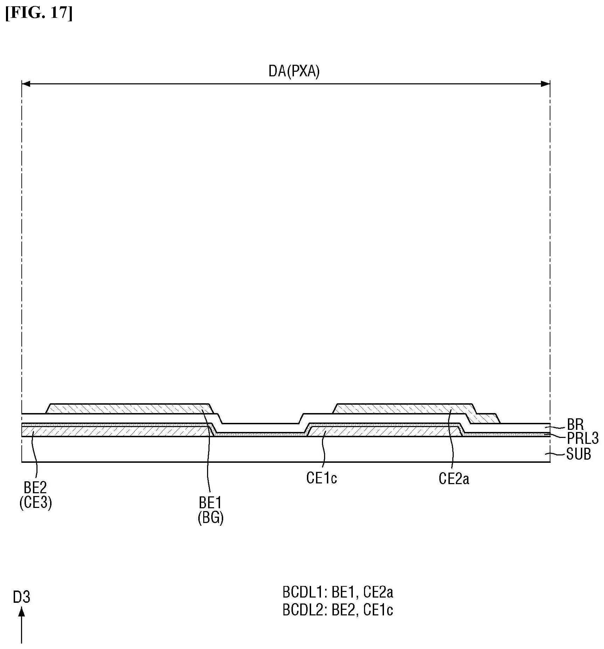

Referring to FIG. 17, the first bottom conductive layer BCDL1 may be formed on the barrier layer BR. For example, the first bottom conductive layer BCDL1 including the first bottom electrode BE1 and the first sub-electrode CE2a of the second capacitor electrode CE2 may be formed on the barrier layer BR.

The patterns (e.g., the first bottom electrode BE1, and the first sub-electrode CE2a of the second capacitor electrode CE2) of the first bottom conductive layer BCDL1 may be formed by a film forming process of a conductive layer that uses at least one conductive material exemplified above and a patterning process of the conductive layer. In one embodiment, each of the patterns of the first bottom conductive layer BCDL1 may be formed, as shown in FIG. 11, as a double layer including the first metal layer ML1a and the second metal layer ML1b, or may be formed, as shown in FIG. 12, as a triple layer including the first metal layer ML1a, the second metal layer ML1b, and the third metal layer ML1c.

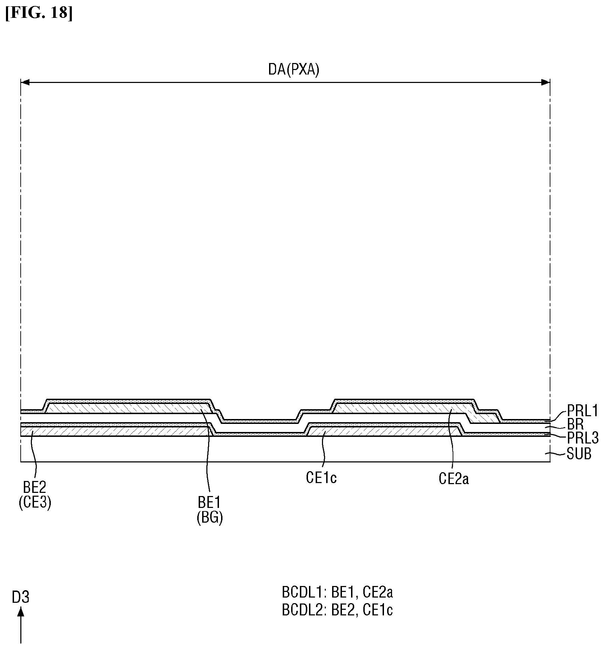

Referring to FIG. 18, the first passivation layer PRL1 covering the first bottom conductive layer BCDL1 may be formed on the barrier layer BR (or the substrate SUB). For example, the first passivation layer PRL1 may be formed on the patterns of the first bottom conductive layer BCDL1 including the first bottom electrode BE1 and the first sub-electrode CE2a of the second capacitor electrode CE2. The first passivation layer PRL1 may be formed by a film forming process of an insulating layer that uses the previously exemplified materials (e.g., at least one of silicon nitride (SiNₓ), silicon oxide (SiOₓ), and silicon oxynitride (SiON), and at least one of fluorine (F), chlorine (Cl), carbon (C), and sulfur (S)). The first passivation layer PRL1 may be formed to cover the side surface of the first metal layer ML1a that is not covered by the second metal layer ML1b, the third metal layer ML1c, and the like.

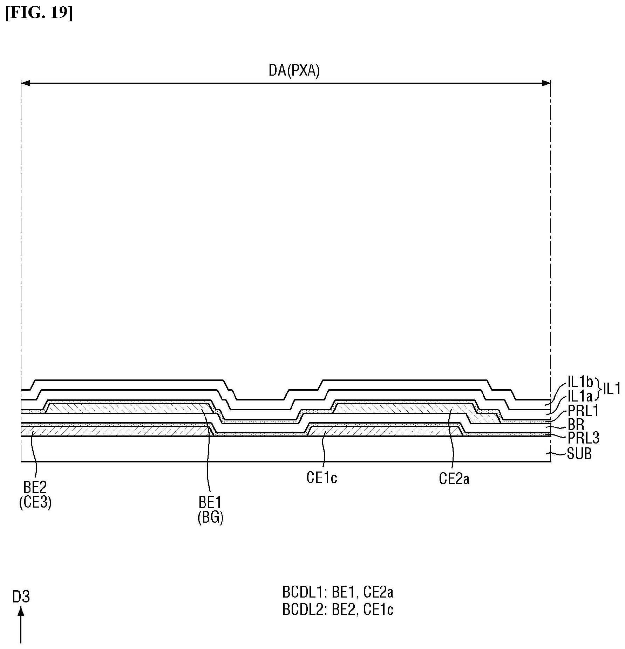

Referring to FIG. 19, the first insulating layer IL1 may be formed on the first passivation layer PRL1. The first insulating layer IL1 may be formed by a film forming process of an insulating layer using at least one insulating material (for example, an inorganic insulating material) exemplified above.

In one embodiment, the first insulating layer IL1 may be formed as at least a double layer including the first layer IL1a and the second layer IL1b. In one example, the double-layer first insulating layer IL1 may be formed by sequentially forming the first layer IL1a (e.g., a silicon nitride layer) and the second layer IL1b (e.g., at least one of a silicon oxide layer or a silicon oxynitride layer) on the first passivation layer PRL1.

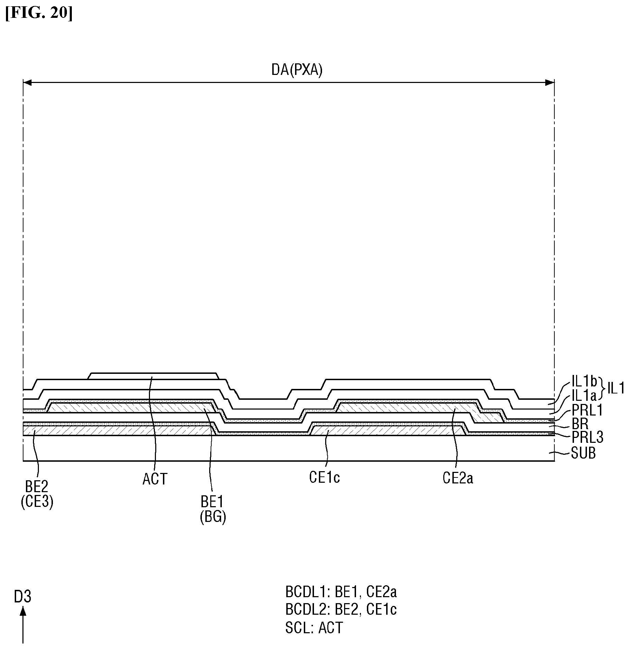

Referring to FIG. 20, the semiconductor layer SCL including the active layer ACT may be formed on the first insulating layer IL1. The active layer ACT may be formed in each transistor region. The active layer ACT may be formed of the previously exemplified material. For example, the active layer ACT including an oxide semiconductor may be formed by performing a film forming process and a patterning process (e.g., an etching process using a mask) of a semiconductor layer that uses at least one oxide semiconductor exemplified above.

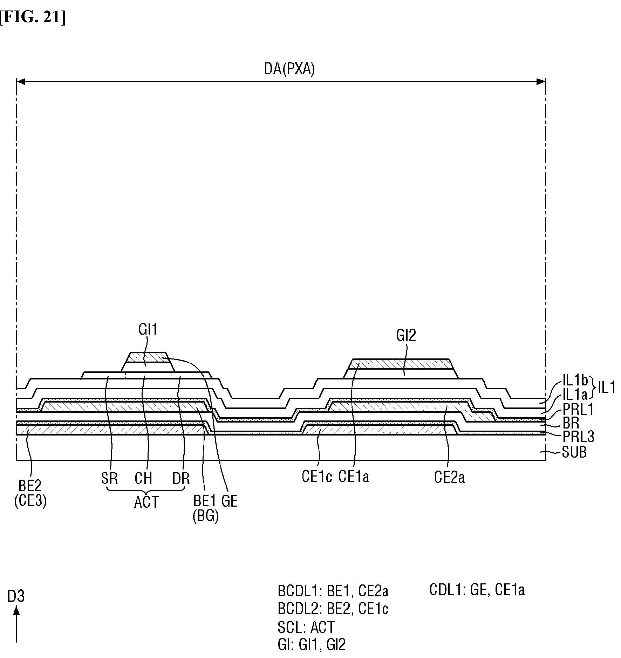

Referring to FIG. 21, the gate insulating layer GI and the first conductive layer CDL1 may be formed on the first insulating layer IL1. The gate insulating layer GI may include the first gate insulating layer GI1 and the second gate insulating layer GI2, and the first conductive layer CDL1 may include the gate electrode GE and the first sub-electrode CE1a of the first capacitor electrode CE1. The first gate insulating layer GI1 and the gate electrode GE may be formed on a portion of the active layer ACT. The second gate insulating layer GI2 and the first sub-electrode CE1a of the first capacitor electrode CE1 may be formed on a portion of the first insulating layer IL1 where the active layer ACT is not disposed.

The gate insulating layer GI may be formed by a film forming process and a patterning process (e.g., an etching process using a mask) of an insulating layer using at least one insulating material (for example, an inorganic insulating material such as silicon oxide) exemplified above.

The patterns (e.g., the gate electrode GE and the first sub-electrode CE1a of the first capacitor electrode CE1) of the first conductive layer CDL1 may be formed by a film forming process of a conductive layer that uses at least one conductive material exemplified above, and a patterning process of the conductive layer. In one embodiment, each of the patterns of the first conductive layer CDL1 may be formed, as shown in FIG. 11, as a double layer including the fourth metal layer ML2a and the fifth metal layer ML2b, or may be formed, as shown in FIG. 12, as a triple layer including the fourth metal layer ML2a, the fifth metal layer ML2b, and the sixth metal layer ML2c.

In one embodiment, the first conductive layer CDL1 and the gate insulating layer GI may be etched sequentially or substantially simultaneously through an etching process using one mask. For example, the gate insulating layer GI may be etched by utilizing the mask used in the etching process of the first conductive layer CDL1 or by utilizing the first conductive layer CDL1 as a mask. Accordingly, the gate insulating layer GI may be patterned into a shape corresponding to the first conductive layer CDL1. For example, the patterns of the gate insulating layer GI may have a shape and/or size corresponding to the patterns of the first conductive layer CDL1.

In the process of etching the gate insulating layer GI, the properties of the active layer ACT may be changed so that parts of the active layer ACT have different characteristics. Accordingly, the active layer ACT may be divided into a plurality of regions having different characteristics.

For example, mainly at a portion that does not overlap the gate electrode GE and the first gate insulating layer GI1, oxygen vacancies may occur in the oxide semiconductor forming the active layer ACT due to an etching gas or the like. Accordingly, the active layer ACT may be divided into a plurality of regions (for example, the channel region CH, the source region SR, and the drain region DR) having different characteristics. In one embodiment, oxygen vacancies may occur mainly at a portion (e.g., the source region SR and the drain region DR) of the active layer ACT that does not overlap the gate electrode GE and the first gate insulating layer GI1, and may diffuse to a portion of the area overlapping the gate electrode GE and/or the first gate insulating layer GI1.

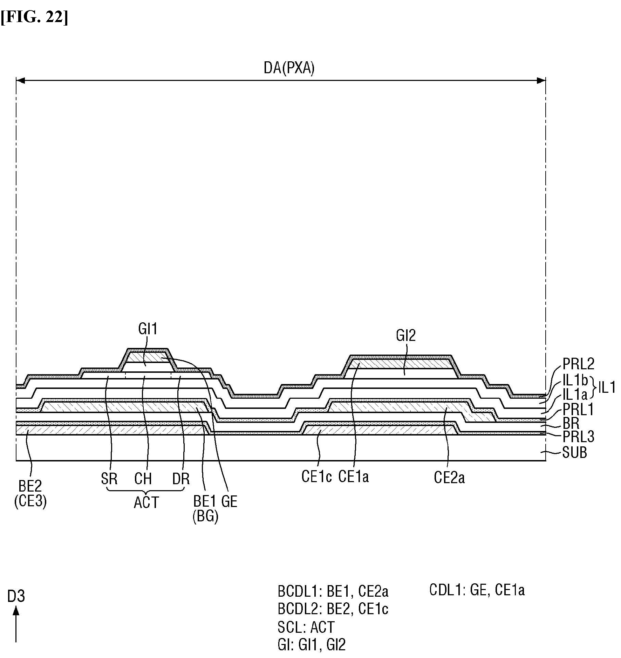

Referring to FIG. 22, the second passivation layer PRL2 covering the semiconductor layer SCL, the gate insulating layer GI, and the first conductive layer CDL4 may be formed on the first insulating layer IL1. For example, the second passivation layer PRL2 may be formed on the patterns of the semiconductor layer SCL, the gate insulating layer GI, and the first conductive layer CDL4. The second passivation layer PRL2 may be formed by a film forming process of an insulating layer that uses the previously exemplified materials (e.g., at least one of silicon oxide (SiOₓ) and silicon oxynitride (SiON), and at least one of fluorine (F), chlorine (Cl), carbon (C), and sulfur (S)). The second passivation layer PRL2 may be formed to cover the side surface of the fourth metal layer ML2a that is not covered by the fifth metal layer ML2b, the sixth metal layer ML2c, and the like.

As in the embodiment of FIG. 4, when manufacturing the display panel 110 that does not include the second passivation layer PRL2, the step of forming the second passivation layer PRL2 may be omitted.

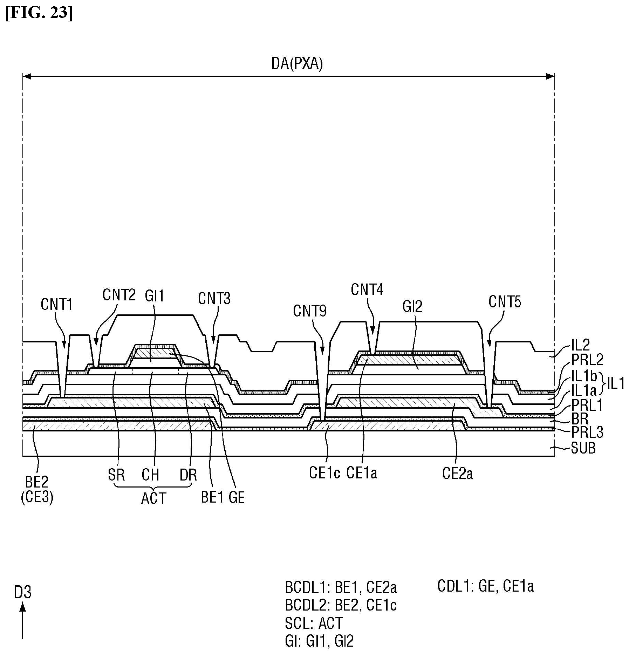

Referring to FIG. 23, the second insulating layer IL2 may be formed on the second passivation layer PRL2. For example, the second insulating layer IL2 may be formed on the active layer ACT, the first and second gate insulating layers GI1 and GI2, the gate electrode GE, and the first sub-electrode CE1a of the first capacitor electrode CE1. The second insulating layer IL2 may be formed by a film forming process of an insulating layer that uses at least one insulating material (e.g., an inorganic insulating material such as silicon oxide (SiOₓ) or silicon oxynitride (SiON)) exemplified above. The second insulating layer IL2 may be formed as a single layer or multiple layers.

Hydrogen may be introduced into the active layer ACT in the process of forming the second insulating layer IL2 and/or the heat treatment process before and after the process. Since hydrogen is introduced into the active layer ACT, a part of the active layer ACT may become conductive (e.g., conductive to N type) mainly at a portion containing a large number of oxygen vacancies. For example, the source region SR and the drain region DR may become conductive.

After film-forming the second insulating layer IL2, a plurality of contact holes may be formed in the second insulating layer IL2. For example, the first, second, third, fourth, fifth, and ninth contact holes CNT1, CNT2, CNT3, CNT4, CNT5, and CNT9 may be formed by an etching process using a mask. In one embodiment, the first, second, third, fourth, fifth, and ninth contact holes CNT1, CNT2, CNT3, CNT4, CNT5, and CNT9 may be formed substantially simultaneously by a single mask process, but the embodiments are not limited thereto.

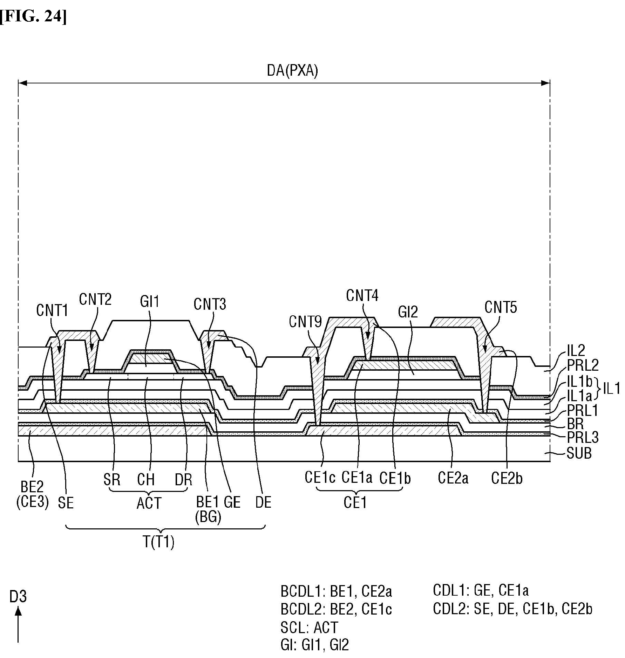

Referring to FIG. 24, the second conductive layer CDL2 may be formed on the second insulating layer IL2. The second conductive layer CDL2 may include the source electrode SE and the drain electrode DE of the transistor T, the second sub-electrode CE1b of the first capacitor electrode CE1, the second sub-electrode CE2b of the second capacitor electrode CE2, and the like. In one embodiment, when at least one of the source region SR or the drain region DR of the active layer ACT replaces at least one of the source electrode SE or the drain electrode DE, at least one of the source electrode SE or the drain electrode DE may not be formed.

The patterns (e.g., the source electrode SE and the drain electrode DE of the transistor T, the second sub-electrode CE1b of the first capacitor electrode CE1, and the second sub-electrode CE2b of the second capacitor electrode CE2) of the second conductive layer CDL2 may be formed by a film forming process of a conductive layer that uses at least one conductive material exemplified above, and a patterning process of the conductive layer.

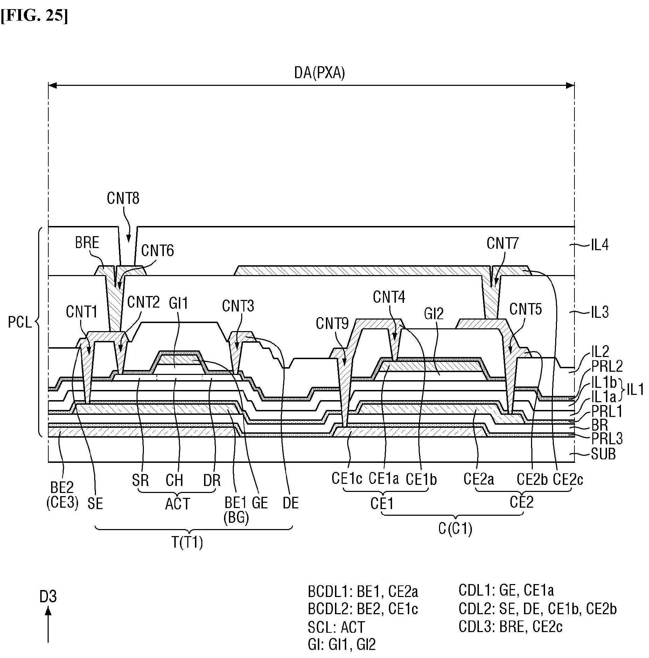

Referring to FIG. 25, the third insulating layer IL3, the third conductive layer CDL3, and the fourth insulating layer IL4 may be sequentially formed on the second insulating layer IL2 and the second conductive layer CDL2. When manufacturing the display panel 110 that does not include the third conductive layer CDL3, the process of forming the third conductive layer CDL3 and the fourth insulating layer IL4 (or the third insulating layer IL3) may be omitted.

The third insulating layer IL3 may be formed on the second insulating layer IL2 by a film forming process of an insulating layer that uses at least one organic insulating material exemplified above. A plurality of contact holes may be formed in the third insulating layer IL3. For example, the sixth contact hole CNT6 and the seventh contact hole CNT7 may be formed in the third insulating layer IL3.

The third conductive layer CDL3 may be formed on the third insulating layer IL3. The third conductive layer CDL3 may include the bridge electrode BRE, and the third sub-electrode CE2c of the second capacitor electrode CE2. In one embodiment, if the second capacitor electrode CE2 does not include the third sub-electrode CE2c, the third sub-electrode CE2c may not be formed.

The patterns of the third conductive layer CDL3 may be formed by a film forming process of a conductive layer that uses at least one conductive material exemplified above, and a patterning process of the conductive layer.

The fourth insulating layer IL4 may be formed on the third insulating layer IL3 and the third conductive layer CDL3. The fourth insulating layer IL4 may be formed by a film forming process of an insulating layer using at least one organic insulating material exemplified above. The eighth contact hole CNT8 exposing the bridge electrode BRE (or the source electrode SE) may be formed in the fourth insulating layer IL4.

Through the above-described processes, the panel circuit layer PCL of the display panel 110 may be formed. As in the embodiments of FIGS. 4, 7, and 10, when the display panel 110 includes the light emitting element layer LEL and the encapsulation layer ENL, the light emitting element layer LEL and the encapsulation layer ENL may be sequentially formed on the panel circuit layer PCL. Through the above-described processes, the display panel 110 and the display device 100 including the same according to the embodiments may be manufactured.

As described above, in the display device 100 and the method for manufacturing the same according to embodiments, a low resistance metal such as aluminium (Al) or copper (Cu) may be used to form a conductive layer (e.g., at least one of the first bottom conductive layer BCDL1 including the first bottom electrode BE1, the second bottom conductive layer BCDL2 including the second bottom electrode BE2, or the first conductive layer CDL1 including the gate electrode GE) of the display panel 110. Accordingly, the resistance of the conductive layer and the display panel 110 including it may be reduced. In addition, by covering the conductive layer with a passivation layer (e.g., at least one of the first passivation layer PRL1, the second passivation layer PRL2, or the third passivation layer PRL3) containing an additive such as fluorine (F), corrosion of the conductive layer may be effectively prevented. Accordingly, the operating characteristics and reliability of the display device 100 may be improved.

For example, in embodiments, the first bottom conductive layer BCDL1 including the first bottom electrode BE1 disposed below the active layer ACT (e.g., the active layer of the oxide transistor T including an oxide semiconductor) may be covered by the first passivation layer PRL1 containing the first additive and at least one of silicon nitride (SiNₓ), silicon oxide (SiOₓ), and silicon oxynitride (SiON), and the first insulating layer IL1 and the active layer ACT may be disposed on the first passivation layer PRL1. Accordingly, the patterns (e.g., electrodes, wires, and/or conductive patterns disposed in the first bottom conductive layer BCDL1) of the first bottom conductive layer BCDL1 may be adequately protected. According to embodiments, by using a low resistance metal to form the first bottom conductive layer BCDL1, the resistance of the first bottom conductive layer BCDL1 may be reduced while preventing corrosion of the first bottom conductive layer BCDL1, thereby increasing the reliability of the display device.

In some embodiments, the patterns of the first bottom conductive layer BCDL1 may be covered by the first passivation layer PRL1 containing fluorine (F). Accordingly, the characteristics of the oxide transistor T including the active layer ACT disposed on the first passivation layer PRL1 may be improved.

In some embodiments, at least one of the first conductive layer CDL1 including the gate electrode GE disposed above the active layer ACT of the oxide transistor T, or the second bottom conductive layer BCDL2 including the second bottom electrode BE2 disposed below the first bottom electrode BE1 may be formed of a low resistance metal and covered by a passivation layer (e.g., at least one of the second passivation layer PRL2 or the third passivation layer PRL3) containing an additive. Accordingly, it is possible to reduce the resistances of at least one of the first conductive layer CDL1 or the second bottom conductive layer BCDL2 while preventing corrosion.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are examples in all respects and not restrictive.

## Claims

1. A display device comprising:
a substrate;
a first bottom electrode disposed on the substrate;
a first passivation layer disposed on the first bottom electrode, and containing at least one of silicon nitride, silicon oxide, and silicon oxynitride, and a first additive;
a first insulating layer disposed on the first passivation layer;
an active layer disposed on the first insulating layer, and containing an oxide semiconductor;
a gate insulating layer disposed on the active layer;
a gate electrode disposed on the gate insulating layer; and
a second insulating layer disposed on the gate electrode,
wherein the first bottom electrode comprises a first metal layer and a second metal layer disposed on the first metal layer and exposing a side surface of the first metal layer, and
the first passivation layer covers the exposed side surface of the first metal layer.

2. The display device of claim 1, wherein the first metal layer contains aluminium or copper, and
the second metal layer contains titanium.

3. The display device of claim 2, wherein the first bottom electrode further comprises a third metal layer disposed below the first metal layer and containing titanium.

4. The display device of claim 1, wherein the first additive contains at least one of fluorine, chlorine, carbon, and sulfur.

5. The display device of claim 4, wherein a concentration of fluorine, chlorine, carbon, or sulfur contained in the first passivation layer is equal to or greater than 2.5 times a concentration of fluorine, chlorine, carbon, or sulfur contained in the first insulating layer.

6. The display device of claim 1, wherein the first passivation layer contains fluorine-added silicon nitride, and
a thickness of the first passivation layer is 100 Å or less.

7. The display device of claim 1, wherein the first insulating layer comprises:
a silicon nitride layer disposed on the first passivation layer; and
at least one of a silicon oxide layer and a silicon oxynitride layer disposed on the silicon nitride layer.

8. The display device of claim 1, wherein the active layer contains at least one of indium-gallium-zinc oxide, indium-tin-gallium-zinc oxide, and indium-gallium oxide.

9. The display device of claim 1, wherein the gate electrode comprises a fourth metal layer containing aluminium or copper, and further comprises at least one of a fifth metal layer containing titanium and disposed on the fourth metal layer and a sixth metal layer containing titanium and disposed below the fourth metal layer.

10. The display device of claim 9, further comprising a second passivation layer disposed between the gate electrode and the second insulating layer to cover the gate electrode, and containing silicon oxide or silicon oxynitride and a second additive.

11. The display device of claim 10, wherein the second additive contains at least one of fluorine, chlorine, carbon, and sulfur.

12. The display device of claim 1, wherein the second insulating layer contains at least one of silicon oxide and silicon oxynitride.

13. The display device of claim 1, further comprising:
a barrier layer disposed between the substrate and the first bottom electrode;
a second bottom electrode disposed between the substrate and the barrier layer; and
a third passivation layer disposed between the second bottom electrode and the barrier layer to cover the second bottom electrode, and containing at least one of silicon nitride, silicon oxide, and silicon oxynitride and a third additive.

14. The display device of claim 13, wherein the second bottom electrode comprises a seventh metal layer containing aluminium or copper, and further comprises at least one of an eighth metal layer disposed on the seventh metal layer and containing titanium and a ninth metal layer disposed below the seventh metal layer and containing titanium.

15. The display device of claim 13, wherein the third additive contains at least one of fluorine, chlorine, carbon, and sulfur.

16. The display device of claim 1, further comprising at least one of a source electrode and a drain electrode, the source and drain electrodes being disposed on the second insulating layer and electrically connected to the active layer,
wherein the first bottom electrode overlaps the active layer and is electrically connected to the source electrode.

17. A method for manufacturing a display device, comprising:
forming, on a substrate, a first bottom electrode comprising a first metal layer and a second metal layer on the first metal layer;
forming, on the substrate, a first passivation layer covering the first bottom electrode and containing at least one of silicon nitride, silicon oxide, or silicon oxynitride and a first additive;
forming a first insulating layer on the first passivation layer;
forming an active layer containing an oxide semiconductor on the first insulating layer;
forming a gate insulating layer and a gate electrode on the active layer; and
forming a second insulating layer on the active layer, the gate insulating layer, and the gate electrode,
wherein the second metal layer exposes a side surface of the first metal layer, and
the first passivation layer covers the exposed side surface of the first metal layer.

18. The method of claim 17, wherein the first additive contains at least one of fluorine, chlorine, carbon, and sulfur.

19. The method of claim 17, further comprising, before forming the second insulating layer, forming a second passivation layer covering the gate electrode and containing silicon oxide or silicon oxynitride and a second additive,
wherein the second additive contains at least one of fluorine, chlorine, carbon, and sulfur.

20. The method of claim 17, further comprising, before forming the first bottom electrode, sequentially forming, on the substrate, a second bottom electrode, a third passivation layer covering the second bottom electrode, and a barrier layer covering the third passivation layer,
wherein the third passivation layer contains at least one of silicon nitride, silicon oxide, and silicon oxynitride, and a third additive containing at least one of fluorine, chlorine, carbon, and sulfur.
